(19) Europäisches Patentamt / European Patent Office / Office européen des brevets

(11) **EP 2 778 700 A2**

(12) **EUROPEAN PATENT APPLICATION**

(43) Date of publication:
**17.09.2014 Bulletin 2014/38**

(51) Int Cl.:
**G01R 31/36** (2006.01)

(21) Application number: **13195162.6**

(22) Date of filing: **29.11.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.03.2013 US 201361778146 P**
**21.06.2013 US 201313924368**

(71) Applicant: **Samsung SDI Co., Ltd.**
**Yongin-si, Gyeonggi-do (KR)**

(72) Inventor: **Kim, Jong-Hoon**
**Gyeonggi-do (KR)**

(74) Representative: **Walaski, Jan Filip et al**
**Venner Shipley LLP**
**200 Aldersgate**
**London**
**EC1A 4HD (GB)**

(54) **Apparatus for predicting state of a battery pack using discrete wavelet transforms**

(57)    Apparatus (10) for predicting state of a battery pack (P1) having a plurality of cells apparatus comprises means (110) for providing cell voltage data ($V_1$ - Vn) over a predetermined time period, means (120) for performing a discrete wavelet transform on the voltage data to obtain low frequency component data (Aj1 - Ajn) and high frequency component data (Dj1-Djn), means (130, 140) for determining standard deviation values for the low frequency component data and/or the high frequency component data, means (170) for predicting state of health SOH of the battery pack based on the determined standard deviation values and means (180, 190) for predicting state of charge SOC of the battery pack based on the low frequency component data.

FIG. 1

EP 2 778 700 A2

**Description**

The present invention relates to an apparatus for predicting a state of a battery pack, and more particularly, to a state of health (SOH) and a state of charge (SOC) of a battery pack by using discrete wavelet transforms.

Along with an increase in as serious problems such as environmental destruction, resource exhaustion, and the like, interest in systems capable of storing energy and efficiently utilizing the stored energy is increasing. In addition, interest in new renewable energy capable of generating energy without inducing pollution is also increasing. An energy storage system, which is a system for linking together a power generation system for generating the new renewable energy, a battery system for storing electrical energy, and an existing system, has been actively researched and developed to meet modern environmental changes.

In the energy storage system, the battery system may store the new renewable energy generated by the power generation system and the electrical energy provided from the existing system and may provide the stored electrical energy to a load or the existing system. In the battery system, estimation of the remaining capacity of a battery is one of important functions. Accurate calculation of the remaining capacity of the battery to control charging and discharging of the battery may enable efficient operation of the energy storage system.

In regard to the remaining capacity of the battery, a resistance and a capacity are deteriorated according to a use environment or a used period, thereby resulting in a decrease in an available capacity or an increase in the resistance, and a decrease in a state of health (SOH) that indicates the performance of the battery compared with an initial manufacturing stage of the battery. Due to the decrease in the SOH of the battery, the estimation of the remaining capacity of the battery is inaccurate compared with the initial manufacturing stage of the battery. When the estimation of the remaining capacity of the battery is inaccurate, not only operating efficiency of the energy storage system decrease, but also a risky status may develop. For example, when a calculated remaining capacity is 30% even though an actual remaining capacity is 80%, a vehicle controller may determine that charging is necessary, thereby overcharging the battery. On the other hand, the battery may be overdischarged. Such overcharging or overdischarging of the battery may cause fire or explosion of the battery. Thus, for an efficient operation and risk prevention with respect to the battery system, the SOH of the battery needs to be accurately estimated.

There exist various SOH estimating methods. A first method is a method of directly measuring a remaining capacity, which is a condition considered to define an SOH of a battery, through a full-charge and full-discharge process. The first method is not efficient since the full-charge and full-discharge process is mandatory.

A second method is a method of detecting an SOH by directly connecting a hardware load of a predetermined frequency to a battery and measuring an impedance of the load. The second method is also not efficient, due to a circuit configuring method, errors, durability, costs of sensors, and the like.

A third method is a method of acquiring current data and voltage data for a predetermined period and determining an indirect impedance and a remaining capacity from the acquired data. The third method also has low accuracy and is very complicated due to inherent nonlinearity and disturbances. In addition, while a magnitude of a resistance component increases as a battery ages, a correlation between a remaining capacity and the resistance component does not unconditionally exist.

Thus, an SOH of a battery needs to be accurately predicted based on an easily obtainable battery pack voltage.

In addition, a conventional battery management system (BMS) has used a method of estimating a state of charge (SOC) by current integration to determine the SOC of a battery cell or pack. The conventional BMS has also used a method of previously determining a relationship between the SOC and factors such as an open circuit voltage (OCV) or a discharge voltage, an internal resistance, a temperature, a discharge current, etc., detecting at least two factors, and detecting the SOC corresponding to the detected factors.

In the SOC estimation method using current integration, problems occur in that an initial value is not correct, measurement errors are accumulated, and an input current is not wholly converted to electric energy, which deteriorates accuracy. Even if the relationship between the SOC and the OCV, etc. is determined, since batteries differ in terms of their characteristics, there are problems in that the relationship between the SOC and the OCV, etc. needs to be experimentally calculated through a complicated experiment for each battery, and a calculated value is also not accurate.

To overcome these disadvantages, as a method of concurrently using the above two methods, an adaptive method of estimating an SOC based on an extended Kalman filter (EKF) using an equivalent circuit model of a battery is proposed. Information related to the estimated SOC is obtained through a state equation, the obtained information is applied to a measurement equation, and an estimation voltage generated according to the relationship between the SOC and the OCV is compared to an actual voltage. In this regard, in a case where a charging and discharging current profile has an instant high current or a fast dynamic, since an error occurs in the equivalent circuit model, the above estimation of the SOC based on the equivalent circuit model is inaccurate.

In such an adaptive method, the above disadvantage may be solved and estimation performance may be increased by increasing an inner state of a system, but an algorithm becomes complicated and expense increases. To solve these problems, although degradation of the SOC estimation performance is inhibited by reducing the inner state of the system to a minimum and adding a noise model to the algorithm, increases in algorithm complexity due to the addition of the noise model and expenses are still problematic.

Accordingly, simplification of the algorithm while maintaining the estimation performance of the algorithm and a reduction in expense are required.

According to the invention there is provided apparatus for predicting state of a battery pack having a plurality of cells, the apparatus comprising means for providing cell voltage data (V1 - Vn) over a predetermined time period, means for performing a discrete wavelet transform on the voltage data to obtain low frequency component data (Aj1 - Ajn) and high frequency component data (Dj1 - Djn), means for determining standard deviation values for the low frequency component data or the high frequency component data, or both, means for predicting state of health SOH of the battery pack based on the determined standard deviation values, and means for predicting state of charge SOC of the battery pack based on the low frequency component data (Aj1 - Ajn).

The means for determining standard deviation values is further configured to determine standard deviation values for the cell voltage data.

The means for providing cell voltage data comprises a cell voltage detection unit arranged to measure cell voltages of cells in the battery pack over the predetermined time period and to digitise the cell voltages to provide the cell voltage data.

The means for determining the standard deviation values may comprise a first standard deviation calculator for calculating first standard deviation values for each of the cell voltage data, low frequency component data and the high frequency component data; and a second standard deviation calculator for calculating respective second standard deviation values for each of the cell voltage data standard deviation values, the low frequency component data standard deviation values and the high frequency component data standard deviation values.

The means for predicting the SOH of the battery pack may comprise an SOH prediction unit arranged to receive the second standard deviation values from the second standard deviation calculator. The second standard deviation calculator may further be arranged to calculate respective third standard deviation values for each of initial cell voltage data standard deviation values, initial low frequency component data standard deviation values and initial high frequency component data standard deviation values.

The apparatus may further comprise a storage unit for storing the third standard deviation values. The third standard deviation values may be arranged to be provided to the SOH prediction unit from the storage unit.

A first component ($SOH_v$) of the predicted value for the state of health based on the cell voltage data may be calculated as:

$$SOH_V = 1 - \frac{\left|\sigma(\sigma_V) - \sigma_0(\sigma_V)\right|}{\alpha\,\sigma_0(\sigma_V)} \qquad 0 \leq SOH_V \leq 1$$

$$SOH_V = 0 \qquad if\ \sigma(\sigma_V) = (\alpha + 1)\sigma_0(\sigma_V)$$

$$SOH_V = 1 \qquad if\ \sigma(\sigma_V) = \sigma_0(\sigma_V)$$

where $\sigma(\sigma_v)$ is the standard deviation of cell voltage standard deviations, $\sigma_0(\sigma_v)$ is the standard deviation of initial cell voltage standard deviations and $\alpha$ is a first coeefficient.

A second component ($SOH_{Aj}$) of the predicted value for the state of health based on the low frequency component data may be calculated as:

$$SOH_{Aj} = 1 - \frac{\left|\sigma(\sigma_{Aj}) - \sigma_0(\sigma_{Aj})\right|}{\beta\,\sigma_0(\sigma_{Aj})} \qquad 0 \leq SOH_{Aj} \leq 1$$

$$SOH_{Aj} = 0 \qquad if\ \sigma(\sigma_{Aj}) = (\beta + 1)\sigma_0(\sigma_{Aj})$$

$$SOH_{Aj} = 1 \qquad if\ \sigma(\sigma_{Aj}) = \sigma_0(\sigma_{Aj})$$

where $\sigma(\sigma_{Aj})$ is the standard deviation of low frequency component standard deviations, $\sigma_0(\sigma_{Aj})$ is the standard deviation of initial low frequency component standard deviations and $\beta$ is a second coeefficient.

A third component ($SOH_{Dj}$) of the predicted value for the state of health based on the high frequency component data may be calculated as:

$$SOH_{Dj} = 1 - \frac{\left| \sigma(\sigma_{Dj}) - \sigma_0(\sigma_{Dj}) \right|}{\gamma \, \sigma_0(\sigma_{Dj})} \qquad 0 \le SOH_{Dj} \le 1$$

$$SOH_{Dj} = 0 \qquad if \ \sigma(\sigma_{Dj}) = (\gamma + 1)\sigma_0(\sigma_{Dj})$$

$$SOH_{Dj} = 1 \qquad if \ \sigma(\sigma_{Dj}) = \sigma_0(\sigma_{Dj})$$

where $\sigma(\sigma_{DJ})$ is the standard deviation of high frequency component standard deviations, $\sigma_0(\sigma_{Dj})$ is the standard deviation of initial high frequency component standard deviations and $\gamma$ is a third coeefficient.

The predicted value for the state of health SOH may be calculated as the mean or weighted mean of the first, second and third components.

The apparatus may further comprise a coefficient storage unit for storing the coefficients to be provided to the SOH prediction unit. The coefficients may be calculated in advance based on characteristics of the battery pack, or based on characteristics of a system that includes the battery pack. The first, second and third coefficients $\alpha$, $\beta$, $\gamma$ may be calculated from the standard deviations of the cell voltage standard deviations, the low frequency component standard deviations and the high frequency component standard deviations respectively.

The first, second and third coefficients $\alpha$, $\beta$, $\gamma$ may be calculated as the ratio of the maximum value to the minimum value of the standard deviations of the cell voltage standard deviations, the low frequency component standard deviations and the high frequency component standard deviations respectively.

The means for predicting the SOC of the battery pack comprises an SOC estimation unit for estimating cell SOCs (SOC1 - SOCn) of the plurality of cells based on the low frequency component data (Aj1 - Ajn), and an SOC prediction unit for predicting the SOC of the battery pack based on the cell SOCs (SOC1 - SOCn) of the plurality of cells.

According to the present invention, there is further provided a method of predicting state of health SOH of a battery pack having a plurality of cells, the method comprising providing cell voltage data (V1 - Vn) over a predetermined time period, performing a discrete wavelet transform on the voltage data to obtain low frequency component data (Aj1 - Ajn) and high frequency component data (Dj1 - Djn), determining standard deviation values for at least one of the cell voltage data, low frequency component data and the high frequency component data and predicting the SOH of the battery pack based on the determined standard deviation values.

The above and other features and advantages of the present invention will become more apparent by describing in detail exemplary embodiments thereof with reference to the attached drawings in which:

FIG. 1 is a schematic block diagram of a battery state prediction apparatus of a battery pack according to an embodiment of the present invention;

FIG. 2 illustrates a scale function and a wavelet function;

FIG. 3 is a schematic block diagram for describing a discrete wavelet transform in terms of filtering;

FIG. 4 illustrates coefficients of a low-pass filter and a high-pass filter;

FIG. 5 is a block diagram for describing a process of decomposing voltage data by performing discrete wavelet transform multi-resolution analysis;

FIG. 6 illustrates down-sampling;

FIG. 7 illustrates a frequency band of approximate voltage data of an nth level and frequency bands of detailed voltage data of first to nth levels;

FIG. 8A is a graph of cell voltage data V(x) of an arbitrary one of a plurality of battery cells included in a battery pack;

FIG. 8B illustrates graphs of low frequency component data A1(x) to A5(x) of first to fifth levels, which are extracted from the cell voltage data V(x) by performing discrete wavelet transform multi-resolution analysis;

FIG. 8C illustrates graphs of high frequency component data D1(x) to D5(x) of the first to fifth levels, which are extracted from the cell voltage data V(x) by performing discrete wavelet transform multi-resolution analysis;

FIG. 9A is a graph of cell voltage data V of 14 battery cells included in a battery pack;

FIG. 9B is a graph of low frequency component data A5 of the fifth level, which is extracted by performing discrete wavelet transform multi-resolution analysis on each of the cell voltage data V;

FIG. 9C is a graph of high frequency component data D5 of the fifth level, which is extracted by performing discrete wavelet transform multi-resolution analysis on each of the cell voltage data V;

FIGS. 10A to 10I are graphs showing cell voltage data V of 14 battery cells included in second to tenth battery packs P2 to P10, graphs showing low frequency component data A5 of the fifth level, and graphs showing high frequency component data D5 of the fifth level; and

FIGS. 11A and 11B are graphs verifying the accuracy of SOC estimation, according to an embodiment of the present invention.

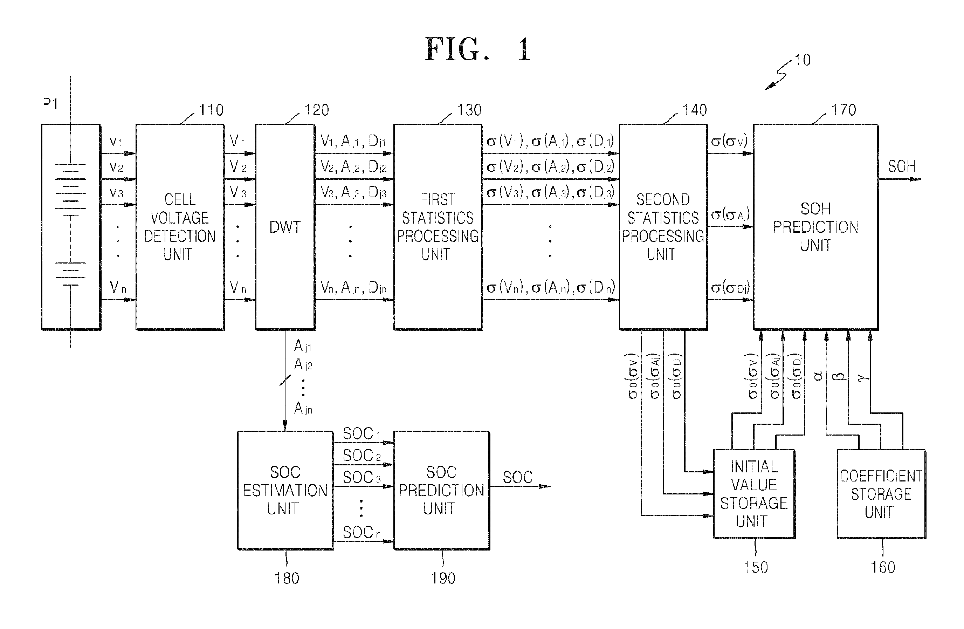

Referring to FIG. 1, the battery state prediction apparatus 10 may be connected to the battery pack P1 and may include a voltage detection unit 110, a discrete wavelet transform (DWT) unit 120, a first statistics processing unit 130, a second statistics processing unit 140, an initial value storage unit 150, a coefficient storage unit 160, an SOH prediction unit 170, an SOC estimation unit 180, and an SOC prediction unit 190.

The battery pack P1 includes a plurality of battery cells capable of receiving electrical energy from the outside, storing the electrical energy, and supplying the stored electrical energy to the outside. The battery cells in the battery pack P1 may be connected in series or parallel to each other or connected to each other in a form of a combination of a series connection and a parallel connection.

The battery pack P1 may be included in a battery system (not shown). The battery system may include the battery pack P1, a protection circuit for protecting the battery pack P1, and a battery management system (BMS) for controlling the protection circuit to protect the battery pack P1. For example, in a case of a flow of overcurrent or overdischarging, the BMS may open a switch of the protection circuit to open terminals of the battery pack P1. In addition, the BMS may collect various kinds of data, such as voltage data, current data, and temperature data, by monitoring states, e.g., a temperature, a voltage, a current, and the like, of the battery cells in the battery pack P1. The BMS may perform a cell balancing operation of the battery cells according to the collected data and an internal algorithm. The battery state prediction apparatus 10 may be included in the BMS.

The battery system including the battery pack P1 may be a portion of an energy storage system for stably supplying power to a load by linking to a power generation system and a grid system. The energy storage system may store electrical energy generated by the power generation system in a battery or supply the generated electrical energy to the grid system, supply the stored electrical energy to the grid system, or store electrical energy supplied from the grid system in the battery. In addition, the energy storage system may supply the electrical energy generated by the power generation system or the electrical energy stored in the battery to the load. To this end, the energy storage system may include a power conversion system (PCS), the battery system, a first switch, and a second switch.

The PCS may include power conversion devices, such as an inverter, a converter, a rectifier, and the like, and a general controller to convert electrical energy provided from the power generation system, the system, and the battery system to a proper form of electrical energy and supply the converted electrical energy to a location as required. The general controller may monitor states of the power generation system, the system, the battery system, and the load and control the first switch, the second switch, the battery system, and the power conversion devices according to an algorithm or a command of an operator. The battery state prediction apparatus 10 may be included in the general controller of the energy storage system.

Although only one battery pack P1 is shown in FIG. 1, the battery pack P1 may be connected in series, in parallel, or in a combination form of a series connection and a parallel connection to other battery packs (not shown) to store or supply electrical energy of a higher voltage or a larger capacity.

The voltage detection unit 110 generates first to nth cell voltage data $V_1, V_2, V_3, ..., V_n$ by receiving first to nth cell voltages $v_1, v_2, v_3, ..., v_n$ from first to nth battery cells of the battery pack P1 and digitizing the received first to nth cell voltages $v_1, v_2, v_3, ..., v_n$.

In detail, the first cell voltage data $V_1$ is generated by digitizing the first cell voltage $v_1$ of the first battery cell, and the second cell voltage data $V_2$ is generated by digitizing the second cell voltage $v_2$ of the second battery cell. In this manner, the nth cell voltage data $V_n$ is generated by digitizing the nth cell voltage $v_n$ of the nth battery cell.

The first to nth cell voltages $v_1, v_2, v_3, ..., v_n$ may be cell voltages of all battery cells included in the battery pack P1. Alternatively, the first to nth cell voltages $v_1, v_2, v_3, ..., v_n$ may be cell voltages of n battery cells selected from among all battery cells included in the battery pack P1. The first to nth cell voltages $v_1, v_2, v_3, ..., v_n$ have analog values varying over a time t. A same current profile may be applied to the battery cells included in the battery pack P1.

The first to nth cell voltage data $V_1, V_2, V_3, ..., V_n$ have digital values generated by digitizing the first to nth cell voltages $v_1, v_2, v_3, ..., v_n$ over the time t, respectively, and are defined according to a time x. The time x corresponds to the time t. The voltage detection unit 110 may include a plurality of analog-digital converters (ADCs: not shown) for converting the first to nth analog cell voltages $v_1, v_2, v_3, ..., v_n$ to the first to nth digital cell voltage data $V_1, V_2, V_3, ..., V_n$.

The voltage detection unit 110 may store the first to nth cell voltage data $V_1, V_2, V_3, ..., V_n$ needed to predict an SOH of the battery pack P1. To this end, the voltage detection unit 110 may further include a memory device (not shown).

The first to nth cell voltage data $V_1, V_2, V_3, ..., V_n$ needed to predict an SOH of the battery pack P1 may be data of the first to nth cell voltages $v_1, v_2, v_3, ..., v_n$ for a duration selected from, for example, several minutes to tens of hours. For example, the voltage detection unit 110 may store the first to nth cell voltage data $V_1, V_2, V_3, ..., V_n$ obtained by digitizing the first to nth analog cell voltages $v_1, v_2, v_3 , ..., v_n$ for 24 hours. The data collection period is only illustrative and may be a shorter time, such as 1 hour, or a longer time, such as 48 hours, than 24 hours.

In addition, a sampling rate of the voltage detection unit 110 may be 1 to 600 samples per minute. However, the sampling rate does not limit the present disclosure and may be less than 1 sample per minute or greater than 600 samples per minute.

The voltage detection unit 110 may provide the first to nth cell voltage data $V_1$, $V_2$, $V_3$, ..., $V_n$ collected for a predetermined time to the DWT unit 120.

The DWT unit 120 may generate first to nth low frequency component data $A_{j1}$, $A_{j2}$, $A_{j3}$, ..., $A_{jn}$ of a jth level and first to nth high frequency component data $D_{j1}$, $D_{j2}$, $D_{j3}$, ..., $D_{jn}$ of the jth level by performing discrete wavelet transform multi-resolution analysis on the first to nth cell voltage data $V_1$, $V_2$, $V_3$, ..., $V_n$ provided from the voltage detection unit 110. In the current embodiment, it is assumed that the multi-resolution analysis of the discrete wavelet transform is performed up to the jth level, where j is a natural number greater than 2.

The first to nth low frequency component data $A_{j1}$, $A_{j2}$, $A_{j3}$, ..., $A_{jn}$ of the jth level and the first to nth high frequency component data $D_{j1}$, $D_{j2}$, $D_{j3}$, ..., $D_{jn}$ of the jth level also have digital values defined according to the time x.

Although it has been described in the current embodiment that the first to nth low frequency component data $A_{j1}$, $A_{j2}$, $A_{j3}$, ..., $A_{jn}$ and the first to nth high frequency component data $D_{j1}$, $D_{j2}$, $D_{j3}$, ..., $D_{jn}$ of a final level, i.e., the jth level, are extracted, first to nth low frequency component data $A_{j1}$, $A_{j2}$, $A_{j3}$, ..., $A_{jn}$ and first to nth high frequency component data $D_{j1}$, $D_{j2}$, $D_{j3}$, ..., $D_{jn}$ of an intermediate level not the final level, i.e., a kth level, may be extracted by the DWT unit 120, where k is a natural number that is greater than 1 and less than j.

The DWT unit 120 may extract the first low frequency component data $A_{j1}$ of the jth level and the first high frequency component data $D_{j1}$ of the jth level by performing the multi-resolution analysis of the discrete wavelet transform for the first cell voltage data $V_1$. In addition, the DWT unit 120 may extract the second low frequency component data $A_{j2}$ of the jth level and the second high frequency component data $D_{j2}$ of the jth level by performing the discrete wavelet transform multi-resolution analysis on the second cell voltage data $V_2$. In this manner, the DWT unit 120 may extract the nth low frequency component data $A_{jn}$ of the jth level and the nth high frequency component data $D_{jn}$ of the jth level by performing the multi-resolution analysis of the discrete wavelet transform for the nth cell voltage data $V_n$.

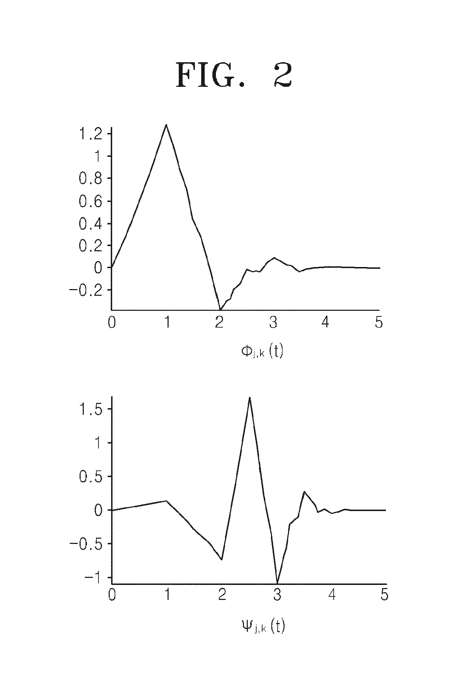

The discrete wavelet transform will be described in detail below with reference to FIGS. 2 to 7.

The SOC estimation unit 180 receives the first to nth low frequency component data $A_{j1}$, $A_{j2}$, $A_{j3}$, ..., $A_{jn}$ of the jth level from the DWT unit 120, and generates the first to nth cell SOCs $SOC_1$, $SOC_2$, $SOC_3$, ..., $SOC_n$ based on the first to nth low frequency component data $A_{j1}$, $A_{j2}$, $A_{j3}$, ..., $A_{jn}$ of the jth level. The SOC prediction unit 190 generates the SOC of the battery pack P1 based on the the first to nth cell SOCs $SOC_1$, $SOC_2$, $SOC_3$, ..., $SOC_n$ according to the connection relation of the plurality of battery cells in the battery pack P1.

The SOC estimation unit 180 may estimate the first to nth cell SOCs $SOC_1$, $SOC_2$, $SOC_3$, ..., $SOC_n$ of each of the plurality of battery cells based on an extended Kalman filter (EKF). A battery terminal voltage and an input current are necessary for estimating the SOC based on the EKF. An open circuit voltage (OCV) calculation equation and an OCV and SOC relationship need to be determined by using a parameter value of an equivalent circuit model of the battery. According to the present example, the first to nth low frequency component data $A_{j1}$, $A_{j2}$, $A_{j3}$, ..., $A_{jn}$ of the jth level extracted by the DWT unit 120 is provided to the SOC estimation unit 180 instead of the voltage data of terminal voltages of the battery cells. Data such as current data may be input into the SOC estimation unit 180 in addition to the first to nth low frequency component data $A_{j1}$, $A_{j2}$, $A_{j3}$, ..., $A_{jn}$ of the jth level. Also, the OCV calculation equation and the OCV and SOC relationship according to the equivalent circuit model of the battery may be built in the SOC estimation unit 180. However, the equivalent circuit model applied to the SOC estimation unit 180 may not include a noise model.

In the case where the plurality of battery cells are connected in parallel in the battery pack P1, the SOC prediction unit 190 may predict that the SOC of the battery pack P1 is an arithmetic mean of the first to nth cell SOCs $SOC_1$, $SOC_2$, $SOC_3$, ..., $SOC_n$. In the case where the plurality of battery cells are connected in serial in the battery pack P1, the SOC prediction unit 190 may predict that the SOC of the battery pack P1 is an minimum value of the first to nth cell SOCs $SOC_1$, $SOC_2$, $SOC_3$, ..., $SOC_n$. The present invention is not limited to the example ways, and the SOC prediction unit 190 may predict the SOC of the battery pack P1 by using other ways or calculation equations based on the first to nth cell SOCs $SOC_1$, $SOC_2$, $SOC_3$, ..., $SOC_n$.

The first statistics processing unit 130 may generate first to nth cell voltage standard deviations $\sigma(V_1)$, $\sigma(V_2)$, $\sigma(V_3)$, ..., $\sigma(V_n)$, first to nth low frequency component standard deviations $\sigma(A_{j1})$, $\sigma(A_{j2})$, $\sigma(A_{j3})$, ..., $\sigma(A_{jn})$, and first to nth high frequency component standard deviations $\sigma(D_{j1})$, $\sigma(D_{j2})$, $\sigma(D_{j3})$, ..., $\sigma(D_{jn})$ by receiving the first to nth cell voltage data $V_1$, $V_2$, $V_3$, ..., $V_n$, the first to nth low frequency component data $A_{j1}$, $A_{j2}$, $A_{j3}$, ..., $A_{jn}$ of the jth level, and the first to nth high frequency component data $D_{j1}$, $D_{j2}$, $D_{j3}$, ..., $D_{jn}$ of the jth level and calculating a standard deviation for each of them.

The first statistics processing unit 130 generates the first to nth cell voltage standard deviations $\sigma(V_1)$, $\sigma(V_2)$, $\sigma(V_3)$, ..., $\sigma(V_n)$ by calculating a standard deviation for each of the first to nth cell voltage data $V_1$, $V_2$, $V_3$, ..., $V_n$ for a predetermined time. The first cell voltage standard deviation $\sigma(V_1)$ has a standard deviation value of the first cell voltage data $V_1$ having a digital value varying over the time x. In this manner, the nth cell voltage standard deviation $\sigma(V_n)$ has a standard deviation value of the nth cell voltage data $V_n$ having a digital value varying over the time x.

A small value of a kth cell voltage standard deviation $\sigma(V_k)$ indicates that a variation of a kth cell voltage $v_k$ of a kth battery cell for the predetermined time is small, and a large value of the kth cell voltage standard deviation $\sigma(V_k)$ indicates that a variation of the kth cell voltage $v_k$ of the kth battery cell for the predetermined time is large. Herein, the kth battery cell indicates an arbitrary battery cell in the battery pack P1.

In addition, the kth cell voltage standard deviation $\sigma(V_k)$, which is greater than the first cell voltage standard deviation $\sigma(V_1)$, may indicate that an internal impedance of the kth battery cell is greater than an internal impedance of the first battery cell since a same current profile is applied to the kth battery cell and the first battery cell. Herein, the first battery cell indicates an arbitrary battery cell other than the kth battery cell from among the battery cells in the battery pack P1.

The first statistics processing unit 130 generates the first to nth low frequency component standard deviations $\sigma(A_{j1})$, $\sigma(A_{j2})$, $\sigma(A_{j3})$, ..., $\sigma(A_{jn})$ by calculating a standard deviation for each of the first to nth low frequency component data $A_{j1}$, $A_{j2}$, $A_{j3}$, ..., $A_{jn}$ of the jth level for the predetermined time. The first low frequency component standard deviation $\sigma(A_{j1})$ has a standard deviation value of the first low frequency component data $A_{j1}$ of the jth level of the first battery cell, which has a digital value varying over the time x. In this manner, the nth low frequency component standard deviation $\sigma(A_{jn})$ has a standard deviation value of the nth low frequency component data $A_{jn}$ of the jth level of the nth battery cell, which has a digital value varying over the time x.

A small value of a kth low frequency component standard deviation $\sigma(A_{jk})$ indicates that a variation of a component in a first frequency band of a kth cell voltage $v_k$ of a kth battery cell for the predetermined time is small, and a large value of the kth low frequency component standard deviation $\sigma(A_{jk})$ indicates that a variation of the component in the first frequency band of the kth cell voltage $v_k$ of the kth battery cell for the predetermined time is large. Herein, the kth battery cell indicates an arbitrary battery cell in the battery pack P1. The component in the first frequency band of the kth cell voltage $v_k$ of the kth battery cell corresponds to jth low frequency component data $A_{jk}$ of the jth level extracted from kth cell voltage data $V_k$ of the kth battery cell and may be obtained by removing high frequency component noise from the kth cell voltage $v_k$ of the kth battery cell.

The first statistics processing unit 130 generates the first to nth high frequency component standard deviations $\sigma(D_{j1})$, $\sigma(D_{j2})$, $\sigma(D_{j3})$, ..., $\sigma(D_{jn})$ by calculating a standard deviation for each of the first to nth high frequency component data $D_{j1}$, $D_{j2}$, $D_{j3}$, ..., $D_{jn}$ of the jth level for the predetermined time. A kth high frequency component standard deviation $\sigma(D_{jk})$ has a standard deviation value of a kth high frequency component data $D_{jk}$ of the jth level of the kth battery cell, which has a digital value varying along the time x. Herein, the kth battery cell indicates an arbitrary battery cell in the battery pack P1.

A small value of the kth high frequency component standard deviation $\sigma(D_{jk})$ indicates that a variation of a component in a second frequency band of a kth cell voltage $v_k$ of the kth battery cell for the predetermined time is small, and a large value of the kth high frequency component standard deviation $\sigma(D_{jk})$ indicates that a variation of the component in the second frequency band of the kth cell voltage $v_k$ of the kth battery cell for the predetermined time is large. The component in the second frequency band of the kth cell voltage $v_k$ of the kth battery cell corresponds to jth high frequency component data $D_{jk}$ of the jth level extracted from kth cell voltage data $V_k$ of the kth battery cell.

For example, the first frequency band indicates a frequency band lower than an arbitrary frequency $f_s$, and the second frequency band indicates a frequency band higher than the arbitrary frequency $f_s$ and lower than double the arbitrary frequency $f_s$.

In addition, the kth high frequency component standard deviation $\sigma(D_{jk})$, which is greater than the first high frequency component standard deviation $\sigma(D_{j1})$, may indicate that an internal impedance of the kth battery cell in the second frequency band is greater than an internal impedance of the first battery cell in the second frequency band. That is, even though a same current profile is applied to the kth battery cell and the first battery cell, a voltage response of the kth battery cell in the second frequency band is greater than a voltage response of the first battery cell in the second frequency band.

The second statistics processing unit 140 generates a standard deviation $\sigma(\sigma_v)$ of cell voltage standard deviations, a standard deviation $\sigma(\sigma_{Aj})$ of low frequency component standard deviations, and a standard deviation $\sigma(\sigma_{Dj})$ of high frequency component standard deviations by receiving the first to nth cell voltage standard deviations $\sigma(V_1)$, $\sigma(V_2)$, $\sigma(V_3)$, ..., $\sigma(V_n)$, the first to nth low frequency component standard deviations $\sigma(A_{j1})$, $\sigma(A_{j2})$, $\sigma(A_{j3})$, ..., $\sigma(A_{jn})$, and the first to nth high frequency component standard deviations $\sigma(D_{j1})$, $\sigma(D_{j2})$, $\sigma(D_{j3})$, ..., $\sigma(D_{jn})$ and performing a standard deviation calculation thereon.

The second statistics processing unit 140 generates the standard deviation $\sigma(\sigma_v)$ of cell voltage standard deviations by calculating a standard deviation for the first to nth cell voltage standard deviations $\sigma(V_1)$, $\sigma(V_2)$, $\sigma(V_3)$, ..., $\sigma(V_n)$ generated by the first statistics processing unit 130.

A small value of the standard deviation $\sigma(\sigma_v)$ of cell voltage standard deviations indicates that a difference between every voltage of the battery cells in the battery pack P1 is small, i.e., that a voltage balance among the battery cells in the battery pack P1 is maintained. For example, when the battery pack P1 is changed from a charging state to a discharging state, voltages of the battery cells in the battery pack P1 vary with a constant potential.

On the contrary, a large value of the standard deviation $\sigma(\sigma_v)$ of cell voltage standard deviations indicates that a difference between every voltage of the battery cells in the battery pack P1 is large, i.e., that a voltage unbalance among the battery cells in the battery pack P1 is large. For example, when the battery pack P1 is changed from a charging state to a discharging state, voltages of the battery cells in the battery pack P1 vary differently, e.g., when a predetermined current file is applied, a cell voltage of the first battery cell decreases by 0.5 V while a cell voltage of the second battery cell decreases by 0.1 V.

The second statistics processing unit 140 generates the standard deviation $\sigma(\sigma_{Aj})$ of low frequency component standard deviations by calculating a standard deviation for the first to nth low frequency component standard deviations $\sigma(A_{j1})$, $\sigma(A_{j2})$, $\sigma(A_{j3})$, ..., $\sigma(A_{jn})$ generated by the first statistics processing unit 130. In addition, the second statistics processing unit 140 generates the standard deviation $\sigma(\sigma_{DJ})$ of high frequency component standard deviations by calculating a standard deviation for the first to nth high frequency component standard deviations $\sigma(D_{j1})$, $\sigma(D_{j2})$, $\sigma(D_{j3})$, ..., $\sigma(D_{jn})$ generated by the first statistics processing unit 130. The second statistics processing unit 140 may provide the standard deviation $\sigma(\sigma_v)$ of cell voltage standard deviations, the standard deviation $\sigma(\sigma_{Aj})$ of low frequency component standard deviations, and the standard deviation $\sigma(\sigma_{DJ})$ of high frequency component standard deviations to the SOH prediction unit 170.

In addition, the second statistics processing unit 140 generates a standard deviation $\sigma_0(\sigma_v)$ of initial cell voltage standard deviations, a standard deviation $\sigma_0(\sigma_{Aj})$ of initial low frequency component standard deviations, and a standard deviation $\sigma_0(\sigma_{Dj})$ of initial high frequency component standard deviations based on first to nth cell voltage standard deviations $\sigma(V_1)$, $\sigma(V_2)$, $\sigma(V_3)$, ..., $\sigma(V_n)$, first to nth low frequency component standard deviations $\sigma(A_{j1})$, $\sigma(A_{j2})$, $\sigma(A_{j3})$, ..., $\sigma(A_{jn})$, and first to nth high frequency component standard deviations $\sigma(D_{j1})$, $\sigma(D_{j2})$, $\sigma(D_{j3})$, ..., $\sigma(D_{jn})$ received from the first statistics processing unit 130 during an initial time when the battery pack P1 initially starts.

The second statistics processing unit 140 provides the standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations generated during the initial time to the initial value storage unit 150.

The initial value storage unit 150 may store the standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations and may provide the standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations to the SOH prediction unit 170 if they are needed to predict an SOH of the battery pack P1.

The coefficient storage unit 160 may store coefficients $\alpha$, $\beta$, and $\gamma$ that are needed for the SOH prediction unit 170 to perform SOH prediction and may provide the coefficients $\alpha$, $\beta$, and $\gamma$ to the SOH prediction unit 170 for the SOH prediction of the battery pack P1.

The coefficient $\alpha$ is needed to predict a cell voltage base SOH($SOH_v$) of the battery pack P1 based on the standard deviation $\sigma(\sigma_v)$ of cell voltage standard deviations. The coefficient $\beta$ is needed to predict a low frequency component base SOH($SOH_{Aj}$) of the battery pack P1 based on the standard deviation $\sigma(\sigma_{Aj})$ of low frequency component standard deviations. The coefficient $\gamma$ is needed to predict a high frequency component base SOH($SOH_{Dj}$) of the battery pack P1 based on the standard deviation $\sigma(\sigma_{DJ})$ of high frequency component standard deviations.

The coefficients $\alpha$, $\beta$, and $\gamma$ may vary according to electrical characteristics and an arrangement structure of the battery cells in the battery pack P1. An operator may determine the coefficients $\alpha$, $\beta$, and $\gamma$ in advance according to the battery pack P1. The coefficients $\alpha$, $\beta$, and $\gamma$ may be determined by an algorithm of the whole system including the battery pack P1. A process of determining the coefficients $\alpha$, $\beta$, and $\gamma$ by the algorithm will be described in more detail below.

The SOH prediction unit 170 may receive the standard deviation $\sigma(\sigma_v)$ of cell voltage standard deviations, the standard deviation $\sigma(\sigma_{Aj})$ of low frequency component standard deviations, and the standard deviation $\sigma(\sigma_{DJ})$ of high frequency component standard deviations from the second statistics processing unit 140. The standard deviation $\sigma(\sigma_v)$ of cell voltage standard deviations, the standard deviation $\sigma(\sigma_{Aj})$ of low frequency component standard deviations, and the standard deviation $\sigma(\sigma_{DJ})$ of high frequency component standard deviations are generated based on cell voltage data collected for a predetermined data collection period, which are needed to predict an SOH of the battery pack P1. In addition, the SOH prediction unit 170 may receive the standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations from the initial value storage unit 150 and may receive the coefficients $\alpha$, $\beta$, and $\gamma$ from the coefficient storage unit 160.

The SOH prediction unit 170 may calculate the cell voltage base SOH($SOH_v$) based on the standard deviation $\sigma(\sigma_v)$ of cell voltage standard deviations, the standard deviation $\sigma_0(\sigma_v)$ of initial cell voltage standard deviations, and the coefficient $\alpha$. In addition, the SOH prediction unit 170 may calculate the low frequency component base SOH($SOH_{Aj}$) based on the standard deviation $\sigma(\sigma_{Aj})$ of low frequency component standard deviations, the standard deviation $\sigma_0(\sigma_{Aj})$ of initial low frequency component standard deviations, and the coefficient $\beta$. In addition, the SOH prediction unit 170 may calculate the high frequency component base SOH($SOH_{Dj}$) based on the standard deviation $\sigma(\sigma_{Dj})$ of high frequency component standard deviations, the standard deviation $\sigma_0(\sigma_{Dj})$ of initial high frequency component standard deviations, and the coefficient $\gamma$.

The SOH prediction unit 170 may predict an SOH of the battery pack P1 by calculating a final SOH(SOH) based on the cell voltage base SOH($SOH_v$), the low frequency component base SOH($SOH_{Aj}$), and the high frequency component base SOH($SOH_{Dj}$). The SOH prediction unit 170 may output the SOH(SOH). The SOH(SOH) may be provided to the BMS in the battery system or the general controller in the energy storage system.

Calculation of the SOH prediction unit 170 will now be described in detail. First, the discrete wavelet transform is described. A wavelet transform is used to decompose a source signal x(t) by transforming a magnitude and a horizontal position of a circular wavelet function. A continuous wavelet transform (CWT) is defined by Equation 1 below.

$$W^f(a,b) = <x(t), \psi_{a,b}(t)> = \frac{1}{\sqrt{a}} \int_{-\infty}^{\infty} x(t)\psi^* \left( \frac{t-b}{a} \right) dt \tag{1}$$

In Equation 1, a and b are parameters respectively indicating a scale and a translation, $\psi(t)$ denotes a wavelet analysis function, and $\psi^*$ denotes a complex conjugate function. A result of Equation 1 is a wavelet coefficient of the scale and translation parameters.

Substitution of $a=2^j$ and $b = k2^j$ into Equation 1 causes a DWT defined by Equation 2 below. In Equation 2, integers j and k are scale and translation variables, respectively.

$$W^f(j,k) = <x(t), \psi_{j,k}(t)> = \frac{1}{\sqrt{2^j}} \int_{-\infty}^{\infty} x(t)\psi^* \left( \frac{t-k2^j}{2^j} \right) dt \tag{2}$$

In one-dimensional signal decomposition using wavelets, a scale function $\varphi$ and a wavelet function $\psi$ are used. The wavelet function $\psi$ is used to obtain a detailed component $D_j$ from the source signal x(t), and the scale function $\varphi$ is used to decompose an approximate component $A_j$ from the source signal x(t). FIG. 2 illustrates the scale function $\varphi$ and the wavelet function $\psi$. The scale function $\varphi$ and the wavelet function $\psi$ shown in FIG. 2 are based on Daubechies 3 (dB3) wavelets.

In the DWT, approximate information $x_a^j(t)$ and detailed information $x_d^j(t)$ obtained at an arbitrary scale j from the source signal x(t) may be represented by Equation 3 below.

$$x_a^j(t) = \sum_k a_{j,k} \phi_k(2^{-j}t) = \sum_k a_{j,k}\phi_{j,k}(t), \quad k \in Z$$
$$x_d^j(t) = \sum_k d_{j,k} \psi_k(2^{-j}t) = \sum_k d_{j,k}\psi_{j,k}(t), \quad k \in Z \tag{3}$$

In Equation 3, $a_{j,k}$ and $d_{j,k}$ denote an approximate coefficient (scale coefficient) and a detailed coefficient (wavelet coefficient), respectively.

The source signal x(t) may be represented by Equation 4 below using the approximate information $x_a^j(t)$ and the detailed information $x_d^j(t)$.

$$x(t) = \sum_k a_{j,k} 2^{-\frac{j}{2}} \phi(2^{-j}t - k) + \sum_{j=1}\sum_k d_{j,k} 2^{-\frac{j}{2}} \psi(2^{-j}t - k) \tag{4}$$

In addition, $a_{j,k}$ and $d_{j,k}$ may be represented by Equation 5 below using the scale function $\varphi$ and the wavelet function $\psi$, respectively.

$$a_{j,k} = <x(t), \phi_{j,k}(t)> = \int_R x(t) 2^{-\frac{j}{2}} \phi^*(2^{-j}t - k)dt$$

$$d_{j,k} = <x(t), \psi_{j,k}(t)> = \int_R x(t) 2^{-\frac{j}{2}} \psi^*(2^{-j}t - k)dt$$

$$(5)$$

The approximate information $x_a{}^j(t)$ corresponds to a scale function $\varphi_{j,k}(t)$ of a low frequency component, and the detailed information $x_d{}^j(t)$ corresponds to a wavelet function $\psi_{j,k}(t)$ of a high frequency component. When the approximate information $x_a{}^j(t)$ and the detailed information $x_d{}^j(t)$ are simplified to A and D, respectively, the source signal x(t) may be represented by Equation 6 below when multi-resolution decomposition of the source signal x(t) is performed up to an nth level.

$$x(t) = A_n + D_1 + D_2 + \cdots + D_{n-1} + D_n$$

$$(6)$$

By adding detailed information $D_n$ to approximate information $A_n$, approximate information $A_{n-1}$ having a one-level higher resolution is obtained. That is, $A_{n-1} = An + D_n$. In addition, the source signal x(t) may be represented by $A_1 + D_1$.

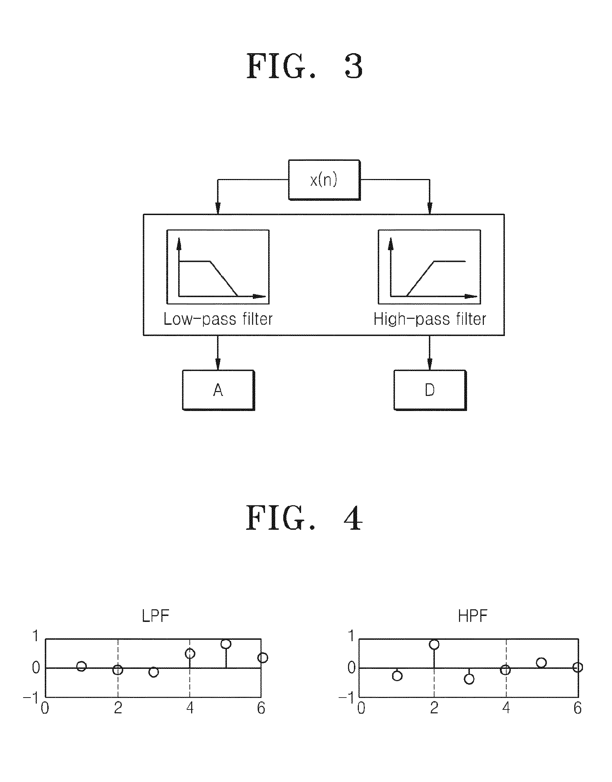

FIG. 3 is a schematic block diagram for describing a DWT in terms of filtering. In the DWT, data x(n) may be decomposed into approximate information A corresponding to a low frequency component and detailed information D corresponding to a high frequency component. A low-pass filter (LPF) may be used to extract the approximate information A from the data x(n). In addition, a high-pass filter (HPF) may be used to extract the detailed information D from the data x(n). The LPF and the HPF are not actual filters, which are implemented physically or by a circuit, but may be implemented by data processing.

FIG. 4 illustrates coefficients of the LPF and the HPF. For example, as shown in FIG. 4, coefficients of the LPF may be {0.0352, -0.0854, -0.1350, 0.4599, 0.8069, 0.3327}, and coefficients of the HPF may be {-0.3327, 0.8069, -0.4599, -0.1350, 0.0854, 0.0352}.

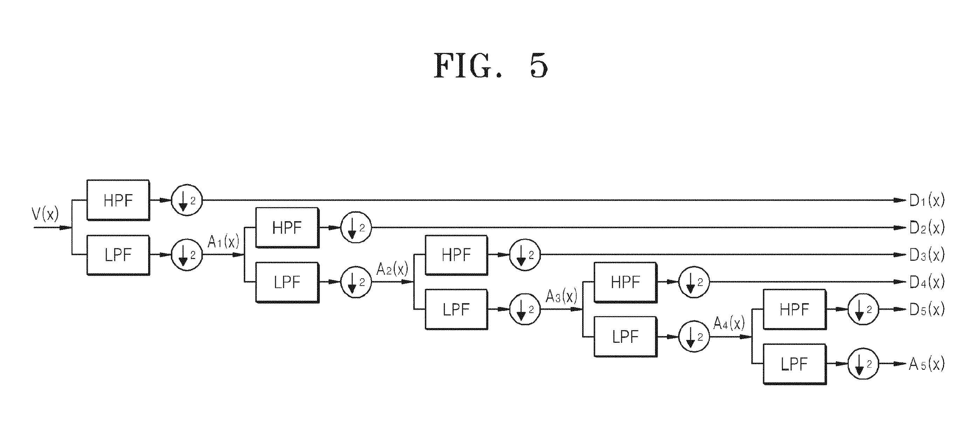

FIG. 5 is a block diagram for describing a process of decomposing voltage data V(x) by a multi-resolution analysis of a DWT. Although it is shown in FIG. 5 that a DWT is repeatedly performed five times, the number of repetitions of a DWT is not limited thereto. That is, a DWT may be performed only once or more than five times.

As described above, a DWT may be performed using the LPF and the HPF.

The voltage data V(x) may be decomposed into approximate voltage data $A_1(x)$ of the first level and detailed voltage data $D_1(x)$ of the first level. The approximate voltage data $A_1(x)$ of the first level may be extracted using the LPF, and the detailed voltage data $D_1(x)$ of the first level may be extracted using the HPF.

The approximate voltage data $A_1(x)$ of the first level may be decomposed into approximate voltage data $A_2(x)$ of the second level and detailed voltage data $D_2(x)$ of the second level by a second DWT and down-sampling.

The approximate voltage data $A_2(x)$ of the second level may be decomposed into approximate voltage data $A_3(x)$ of the third level and detailed voltage data $D_3(x)$ of the third level by a third DWT and down-sampling.

The approximate voltage data $A_3(x)$ of the third level may be decomposed into approximate voltage data $A_4(x)$ of the fourth level and detailed voltage data $D_4(x)$ of the fourth level by a fourth DWT and down-sampling.

The approximate voltage data $A_4(x)$ of the fourth level may be decomposed into approximate voltage data $A_5(x)$ of the fifth level and detailed voltage data $D_5(x)$ of the fifth level by a fifth DWT and down-sampling.

The approximate voltage data $A_5(x)$ of the fifth level and the detailed voltage data $D_5(x)$ of the fifth level, which are extracted by performing discrete wavelet transform multi-resolution analysis on each of the first to nth cell voltage data $V_1$, $V_2$, $V_3$, ..., $V_n$ of the first to nth battery cells, may be respectively provided to the first statistics processing unit 130 as the first to nth low frequency component data $A_{j1}$, $A_{j2}$, $A_{j3}$, ..., $A_{jn}$ of the jth level and the first to nth high frequency component data $D_{j1}$, $D_{j2}$, $D_{j3}$, ..., $D_{jn}$ of the jth level.

As shown in FIG. 5, the voltage data V(x) may be represented using the approximate voltage data $A_5(x)$ of the fifth level and the detailed voltage data $D_1(x)$, $D_2(x)$, $D_3(x)$, $D_4(x)$, $D_5(x)$ of the first to fifth levels. In addition, approximate voltage data $A_{n-1}(x)$ of an (n-1)th level may be represented by a sum of approximate voltage data $A_n(x)$ of the nth level and detailed voltage data $D_n(x)$ of the nth level.

In the current example, the voltage data V(x) may be restored from the approximate voltage data $A_5(x)$ of the fifth level and the detailed voltage data $D_1(x)$, $D_2(x)$, $D_3(x)$, $D_4(x)$, $D_5(x)$ of the first to fifth levels. This restoring process may be referred to as an inverse DWT (IDWT).

As shown in FIG. 5, the repetition of a DWT causes an increase in a total amount of data because the voltage data V(x) is decomposed into approximate voltage data A(x) and detailed voltage data D(x). Thus, down-sampling may be performed after a DWT is performed.

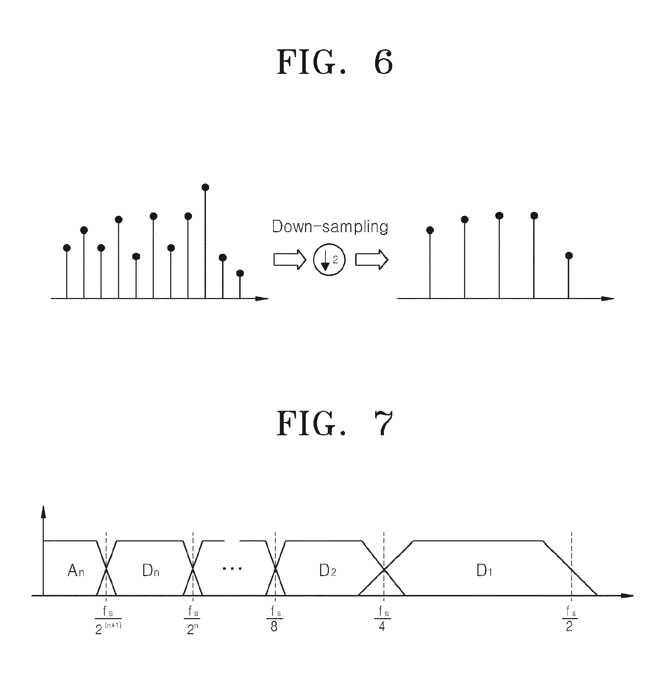

Down-sampling involves selecting event or oddth data of approximate voltage data generated by a previous DWT and removing non-selected data. FIG. 6 illustrates down-sampling. As shown in FIG. 6, n pieces of data are reduced to n/2 pieces of data by down-sampling.

FIG. 7 illustrates a frequency band of the approximate voltage data $A_n(x)$ of the nth level and frequency bands of detailed voltage data $D_1(x)$, $D_2(x)$, ..., $D_n(x)$ of the first to nth levels.

When it is assumed that the detailed voltage data $D_1(x)$ of the first level is data of a frequency band that is less than a first frequency $f_s/2$ and greater than a second frequency $f_s/4$, the detailed voltage data $D_2(x)$ of the second level corresponds to data of a frequency band that is less than the second frequency $f_s/4$ and greater than a third frequency $f_s/8$. In addition, the detailed voltage data $D_3(x)$ of the third level corresponds to data of a frequency band that is less than the third frequency $f_s/8$ and greater than a fourth frequency $f_s/16$. In addition, the detailed voltage data $D_n(x)$ of the nth level corresponds to data of a frequency band that is less than an nth frequency $f_s/2^n$ and greater than an (n+1)th frequency $f_s/2^{n+1}$. In addition, the approximate voltage data $A_n(x)$ of the nth level corresponds to data of a frequency band that is less than the (n+1)th frequency $f_s/2^{n+1}$.

A method of predicting an SOH of the battery pack P1 according to various embodiments of the present invention will now be described with respect to a detailed example.

In the example below, it is assumed that the battery pack P1 includes 14 battery cells. The battery pack P1 may consist of 14 battery cells connected in series. According to another example, the battery pack P1 may include 70 battery cells connected in series, wherein 14 of the 70 battery cells are selected to predict an SOH. In addition, it is assumed that discrete wavelet transform multi-resolution analysis is performed up to a fifth level.

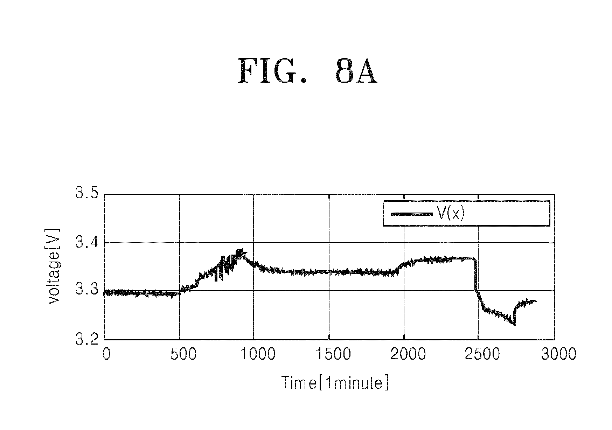

Referring to FIG. 8A, a graph of the cell voltage data V(x) over a time x is illustrated. In the graph of FIG. 8A, the cell voltage data V(x) is data obtained by measuring a cell voltage for 2880 minutes, i.e., 48 hours. Since the cell voltage data V(x) is obtained by measuring a cell voltage of battery cells actually being used, the cell voltage may increase due to charging and may decrease due to discharging for 48 hours. The cell voltage data V(x) may be generated by the cell voltage detection unit 110. In detail, the cell voltage data V(x) may be generated by the BMS in the battery system.

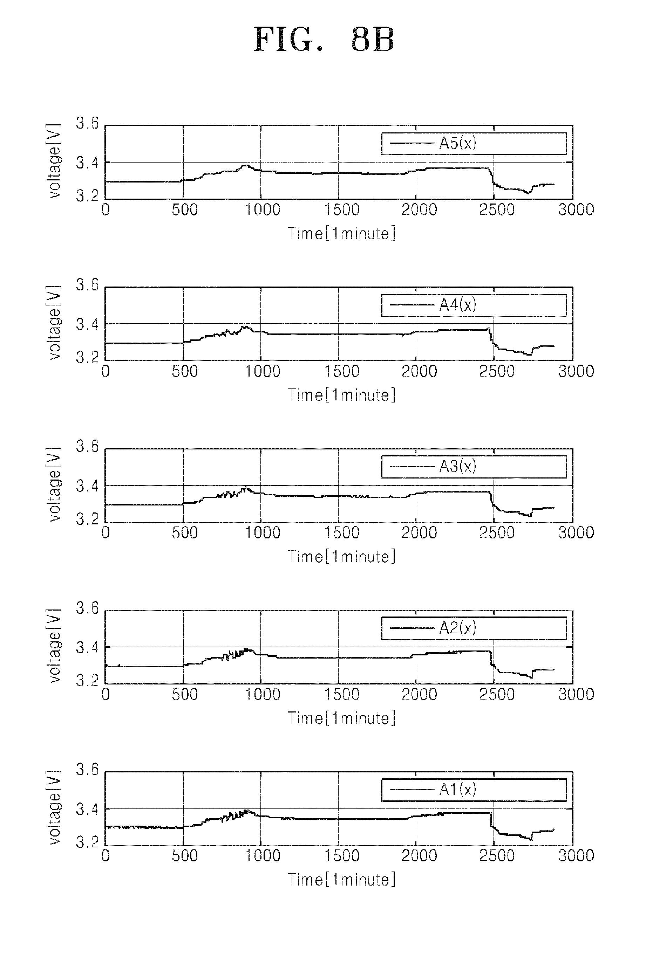

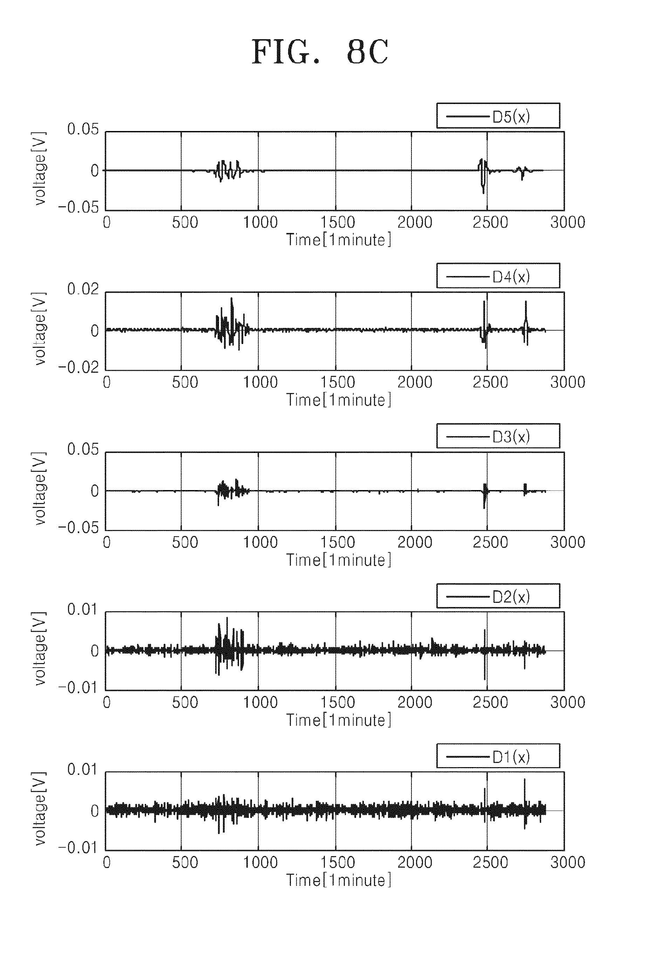

FIG. 8B illustrates graphs of low frequency component data A1(x) to A5(x) of the first to fifth levels, which are extracted by performing discrete wavelet transform multi-resolution analysis on the cell voltage data V(x) shown in FIG. 8A. In addition, FIG. 8C illustrates graphs of high frequency component data D1(x) to D5(x) of the first to fifth levels, which are extracted by performing discrete wavelet transform multi-resolution analysis on the cell voltage data V(x) shown in FIG. 8A.

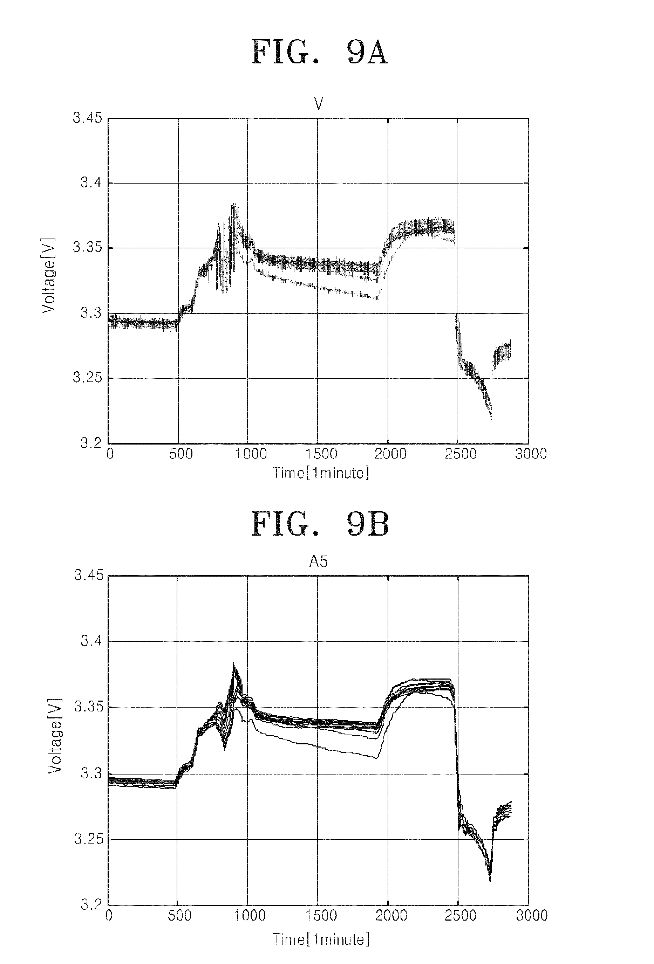

FIG. 9A is a graph of cell voltage data V of the 14 battery cells included in the battery pack P1. Referring to FIG. 9A, first to fourteenth cell voltage data $V_1$, $V_2$, $V_3$, ..., $V_{14}$ of the first to fourteenth battery cells are shown without being distinguished from each other.

The first to fourteenth cell voltage data $V_1$, $V_2$, $V_3$, ..., $V_{14}$ are collected for the first to fourteenth battery cells, respectively. The first to fourteenth cell voltage data $V_1$, $V_2$, $V_3$, ..., $V_{14}$ may be collected by the cell voltage detection unit 110.

The first to fourteenth cell voltage data $V_1$, $V_2$, $V_3$, ..., $V_{14}$ may be provided to the DWT unit 120 and the first statistics processing unit 130, and the first statistics processing unit 130 may generate first to fourteenth cell voltage standard deviations $\sigma(V_1)$, $\sigma(V_2)$, $\sigma(V_3)$, ..., $\sigma(V_{14})$ by calculating a standard deviation for each of the first to fourteenth cell voltage data $V_1$, $V_2$, $V_3$, ..., $V_{14}$.

The first to fourteenth cell voltage standard deviations $\sigma(V_1)$, $\sigma(V_2)$, $\sigma(V_3)$, ..., $\sigma(V_{14})$ may be calculated as shown in Table 1.

Table 1

| $\sigma(V_1)$ | 0.035099 | $\sigma(V_2)$ | 0.034938 | $\sigma(V_3)$ | 0.034994 |
|---|---|---|---|---|---|
| $\sigma(V_4)$ | 0.034610 | $\sigma(V_5)$ | 0.034659 | $\sigma(V_6)$ | 0.034021 |
| $\sigma(V_7)$ | 0.033722 | $\sigma(V_8)$ | 0.035657 | $\sigma(V_9)$ | 0.035878 |
| $\sigma(V_{10})$ | 0.032827 | $\sigma(V_{11})$ | 0.035987 | $\sigma(V_{12})$ | 0.035743 |
| $\sigma(V_{13})$ | 0.036270 | $\sigma(V_{14})$ | 0.036108 | | |

The second statistics processing unit 140 may generate a standard deviation $\sigma(\sigma_v)$ of cell voltage standard deviations by receiving the first to fourteenth cell voltage standard deviations $\sigma(V_1)$, $\sigma(V_2)$, $\sigma(V_3)$, ..., $\sigma(V_{14})$ calculated by the first statistics processing unit 130 and performing a standard deviation calculation for the received first to fourteenth cell voltage standard deviations $\sigma(V_1)$, $\sigma(V_2)$, $\sigma(V_3)$, ..., $\sigma(V_{14})$.

The calculated standard deviation $\sigma(\sigma_v)$ of cell voltage standard deviations may be 0.001005.

FIG. 9B is a graph of low frequency component data A5 of the fifth level, which is extracted by performing discrete wavelet transform multi-resolution analysis on each of the cell voltage data V. Referring to FIG. 9B, first to fourteenth low frequency component data $A5_1$, $A5_2$, $A5_3$, ..., $A5_{14}$ of the fifth level generated from the first to fourteenth cell voltage data $V_1$, $V_2$, $V_3$, ..., $V_{14}$ of the first to fourteenth battery cells are shown without being distinguished from each other.

The first to fourteenth low frequency component data $A5_1$, $A5_2$, $A5_3$, ..., $A5_{14}$ of the fifth level are respectively extracted from the first to fourteenth cell voltage data $V_1$, $V_2$, $V_3$, ..., $V_{14}$ of the first to fourteenth battery cells.

The DWT unit 120 may generate the first to fourteenth low frequency component data $A5_1$, $A5_2$, $A5_3$, ..., $A5_{14}$ of the fifth level by performing discrete wavelet transform multi-resolution analysis on the first to fourteenth cell voltage data $V_1$, $V_2$, $V_3$, ..., $V_{14}$ of the first to fourteenth battery cells.

The first statistics processing unit 130 may generate first to fourteenth low frequency component standard deviations $\sigma(A5_1)$, $\sigma(A5_2)$, $\sigma(A5_3)$, ..., $\sigma(A5_{14})$ by receiving the first to fourteenth low frequency component data $A5_1$, $A5_2$, $A5_3$, ..., $A5_{14}$ of the fifth level and calculating a standard deviation for each of the first to fourteenth low frequency component data $A5_1$, $A5_2$, $A5_3$, ... $A5_{14}$ of the fifth level.

The first to fourteenth low frequency component standard deviations $\sigma(A5_1)$, $\sigma(A5_2)$, $\sigma(A5_3)$, ..., $\sigma(A5_{14})$ may be calculated as shown in Table 2 below.

Table 2

| $\sigma(A5_1)$ | 0.034929 | $\sigma(A5_2)$ | 0.034770 | $\sigma(A5_3)$ | 0.034834 |
|---|---|---|---|---|---|
| $\sigma(A5_4)$ | 0.034443 | $\sigma(A5_5)$ | 0.034483 | $\sigma(A5_6)$ | 0.033868 |
| $\sigma(A5_7)$ | 0.033586 | $\sigma(A5_8)$ | 0.035509 | $\sigma(A5_9)$ | 0.035730 |
| $\sigma(A5_{10})$ | 0.032684 | $\sigma(A5_{11})$ | 0.035844 | $\sigma(A5_{12})$ | 0.035601 |
| $\sigma(A5_{13})$ | 0.036102 | $\sigma(A5_{14})$ | 0.035945 | | |

The second statistics processing unit 140 may generate a standard deviation $\sigma(\sigma_{A5})$ of low frequency component standard deviations by receiving the first to fourteenth low frequency component standard deviations $\sigma(A5_1)$, $\sigma(A5_2)$, $\sigma(A5_3)$, ..., $\sigma(A5_{14})$ calculated by the first statistics processing unit 130 and performing a standard deviation calculation for the first to fourteenth low frequency component standard deviations $\sigma(A5_1)$, $\sigma(A5_2)$, $\sigma(A5_3)$, ..., $\sigma(A_{14})$.

The calculated standard deviation $\sigma(\sigma_{A5})$ of low frequency component standard deviations may be 0.001003.

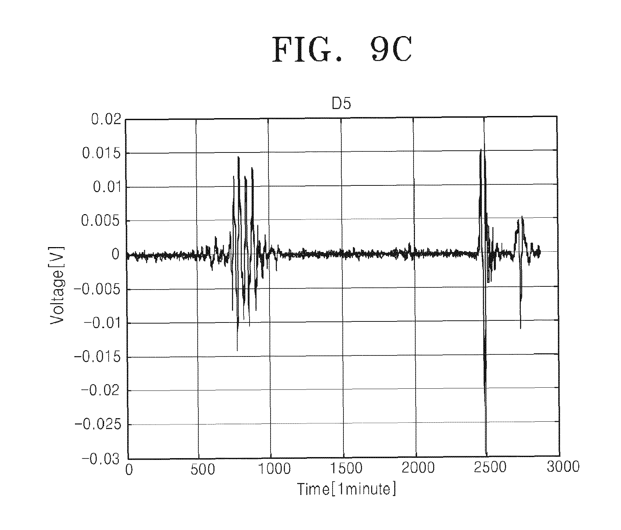

FIG. 9C is a graph of high frequency component data D5 of the fifth level, which is extracted by performing discrete wavelet transform multi-resolution analysis on each of the cell voltage data V. Referring to FIG. 9C, first to fourteenth high frequency component data $D5_1$, $D5_2$, $D5_3$, ..., $D5_{14}$ of the fifth level generated from the first to fourteenth cell voltage data $V_1$, $V_2$, $V_3$, ..., $V_{14}$ of the first to fourteenth battery cells are shown without being distinguished from each other.

The first to fourteenth high frequency component data $D5_1$, $D5_2$, $D5_3$, ... $D5_{14}$ of the fifth level are respectively extracted from the first to fourteenth cell voltage data $V_1$, $V_2$, $V_3$, ..., $V_{14}$ of the first to fourteenth battery cells.

The DWT unit 120 may generate the first to fourteenth high frequency component data $D5_1$, $D5_2$, $D5_3$, ..., $D5_{14}$ of the fifth level by performing discrete wavelet transform multi-resolution analysis on the first to fourteenth cell voltage data $V_1$, $V_2$, $V_3$, ..., $V_{14}$ of the first to fourteenth battery cells.

The first statistics processing unit 130 may generate first to fourteenth high frequency component standard deviations $\sigma(D5_1)$, $\sigma(D5_2)$, $\sigma(D5_3)$, ..., $\sigma(D5_{14})$ by receiving the first to fourteenth high frequency component data $D5_1$, $D5_2$, $D5_3$, ..., $D5_{14}$ of the fifth level and calculating a standard deviation for each of the first to fourteenth high frequency component data $D5_1$, $D5_2$, $D5_3$, ..., $D5_{14}$ of the fifth level.

The first to fourteenth high frequency component standard deviations $\sigma(D5_1)$, $\sigma(D5_2)$, $\sigma(D5_3)$, ..., $\sigma(D5_{14})$ may be calculated as shown in Table 3 below.

Table 3

| $\sigma(D5_1)$ | 0.002436 | $\sigma(D5_2)$ | 0.002455 | $\sigma(D5_3)$ | 0.002420 |
|---|---|---|---|---|---|
| $\sigma(D5_4)$ | 0.002408 | $\sigma(D5_5)$ | 0.002464 | $\sigma(D5_6)$ | 0.002226 |
| $\sigma(D5_7)$ | 0.002054 | $\sigma(D5_8)$ | 0.002262 | $\sigma(D5_9)$ | 0.002199 |
| $\sigma(D5_{10})$ | 0.002022 | $\sigma(D5_{11})$ | 0.002222 | $\sigma(D5_{12})$ | 0.002194 |
| $\sigma(D5_{13})$ | 0.002502 | $\sigma(D5_{14})$ | 0.002441 | | |

The second statistics processing unit 140 may generate a standard deviation $\sigma(\sigma D_5)$ of high frequency component standard deviations by receiving the first to fourteenth high frequency component standard deviations $\sigma(D5_1)$, $\sigma(D5_2)$, $\sigma(D5_3)$, ..., $\sigma(D5_{14})$ calculated by the first statistics processing unit 130 and performing a standard deviation calculation for the first to fourteenth high frequency component standard deviations $\sigma(D5_1)$, $\sigma(D5_2)$, $\sigma(D5_3)$, ..., $\sigma(D5_{14})$.

The calculated standard deviation $\sigma(\sigma_{D5})$ of high frequency component standard deviations may be $1.587865 \times 10^{-4}$.

The standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations may also be generated using the same method as described above. However, in this case, there is a difference in that the first to fourteenth cell voltage data $V_1$, $V_2$, $V_3$, ..., $V_{14}$ are collected from an initial time when the battery pack P1 starts. In addition, the coefficients $\alpha$, $\beta$, and $\gamma$ vary according to the number of battery cells included in the battery pack P1, the number of cell voltage data, an arrangement structure of the battery cells, and the like.

The SOH prediction unit 170 may receive the standard deviation $\sigma(\sigma_v)$ of cell voltage standard deviations, the standard deviation $\sigma(\sigma_{Aj})$ of low frequency component standard deviations, and the standard deviation $\sigma(\sigma_{Dj})$ of high frequency component standard deviations from the second statistics processing unit 140, receive the standard deviation $\sigma_0(\sigma_v)$ of initial cell voltage standard deviations, the standard deviation $\sigma_0(\sigma_{Aj})$ of initial low frequency component standard deviations, and the standard deviation $\sigma_0(\sigma_{Dj})$ of initial high frequency component standard deviations from the initial value storage unit 150, receive the coefficients $\alpha$, $\beta$, and $\gamma$ from the coefficient storage unit 160, and predict an SOH of the battery pack P1 based on the received values.

The SOH prediction unit 170 may calculate the cell voltage base SOH($SOH_v$) based on the standard deviation $\sigma(\sigma_v)$ of cell voltage standard deviations, the standard deviation $\sigma_0(\sigma_v)$ of initial cell voltage standard deviations, and the coefficient $\alpha$.

A formula for calculating the cell voltage base SOH($SOH_v$) may be represented by Equation 7 below.

$$
\begin{aligned}
SOH_V &= 1 - \frac{|\sigma(\sigma_V) - \sigma_0(\sigma_V)|}{\alpha \, \sigma_0(\sigma_V)} \qquad 0 \le SOH_V \le 1 \\
SOH_V &= 0 \qquad if \ \sigma(\sigma_V) = (\alpha + 1)\sigma_0(\sigma_V) \\
SOH_V &= 1 \qquad if \ \sigma(\sigma_V) = \sigma_0(\sigma_V)
\end{aligned}
\tag{7}
$$

The cell voltage base SOH($SOH_v$) having a value of 1 indicates a fresh state of the battery pack P1, and the cell voltage base SOH($SOH_v$) having a value of 0 indicates an aged state of the battery pack P1.

The cell voltage base SOH($SOH_v$) may be calculated based on a difference between the standard deviation $\sigma(\sigma_v)$ of cell voltage standard deviations and the standard deviation $\sigma_0(\sigma_v)$ of initial cell voltage standard deviations and a value obtained by multiplying the standard deviation $\sigma_0(\sigma_v)$ of initial cell voltage standard deviations by the coefficient $\alpha$. As the standard deviation $\sigma(\sigma_v)$ of cell voltage standard deviations is greater than the standard deviation $\sigma_0(\sigma_v)$ of initial cell voltage standard deviations, the cell voltage base SOH($SOH_v$) decreases more, indicating that the battery pack P1 is ageing.

The SOH prediction unit 170 may calculate the low frequency component base SOH($SOH_{Aj}$) based on the standard deviation $\sigma(\sigma_{Aj})$ of low frequency component standard deviations, the standard deviation $\sigma_0(\sigma_{Aj})$ of initial low frequency component standard deviations, and the coefficient $\beta$.

A formula for calculating the low frequency component base SOH($SOH_{Aj}$) may be represented by Equation 8 below.

$$
\begin{aligned}
SOH_{Aj} &= 1 - \frac{|\sigma(\sigma_{Aj}) - \sigma_0(\sigma_{Aj})|}{\beta \, \sigma_0(\sigma_{Aj})} \qquad 0 \le SOH_{Aj} \le 1 \\
SOH_{Aj} &= 0 \qquad if \ \sigma(\sigma_{Aj}) = (\beta + 1)\sigma_0(\sigma_{Aj}) \\
SOH_{Aj} &= 1 \qquad if \ \sigma(\sigma_{Aj}) = \sigma_0(\sigma_{Aj})
\end{aligned}
\tag{8}
$$

The low frequency component base SOH($SOH_{Aj}$) having a value of 1 indicates a fresh state of the battery pack P1, and the low frequency component base SOH($SOH_{Aj}$) having a value of 0 indicates an aged state of the battery pack P1.

The low frequency component base SOH($SOH_{Aj}$) may be calculated based on a difference between the standard deviation $\sigma(\sigma_{Aj})$ of low frequency component standard deviations and the standard deviation $\sigma_0(\sigma_{Aj})$ of initial low frequency component standard deviations and a value obtained by multiplying the standard deviation $\sigma_0(\sigma_{Aj})$ of initial low frequency component standard deviations by the coefficient β. As the standard deviation $\sigma(\sigma_{Aj})$ of low frequency component standard deviations is greater than the standard deviation $\sigma_0(\sigma_{Aj})$ of initial low frequency component standard deviations, the low frequency component base SOH($SOH_{Aj}$) decreases more, indicating that the battery pack P1 is ageing.

The SOH prediction unit 170 may calculate the high frequency component base SOH($SOH_{Dj}$) based on the standard deviation $\sigma(\sigma_{Dj})$ of high frequency component standard deviations, the standard deviation $\sigma_0(\sigma_{Dj})$ of initial high frequency component standard deviations, and the coefficient γ.

A formula for calculating the high frequency component base SOH($SOH_{Dj}$) may be represented by Equation 9 below.

$$SOH_{Dj} = 1 - \frac{\left| \sigma(\sigma_{Dj}) - \sigma_0(\sigma_{Dj}) \right|}{\gamma \, \sigma_0(\sigma_{Dj})} \qquad 0 \le SOH_{Dj} \le 1$$

$$SOH_{Dj} = 0 \qquad if \ \ \sigma(\sigma_{Dj}) = (\gamma + 1)\sigma_0(\sigma_{Dj})$$

$$SOH_{Dj} = 1 \qquad if \ \ \sigma(\sigma_{Dj}) = \sigma_0(\sigma_{Dj})$$

$$(9)$$

The high frequency component base SOH($SOH_{Dj}$) may be calculated based on a difference between the standard deviation $\sigma(\sigma_{Dj})$ of high frequency component standard deviations and the standard deviation $\sigma_0(\sigma_{Dj})$ of initial high frequency component standard deviations and a value obtained by multiplying the standard deviation $\sigma_0(\sigma_{Dj})$ of initial high frequency component standard deviations by the coefficient γ. As the standard deviation $\sigma(\sigma_{Dj})$ of high frequency component standard deviations is greater than the standard deviation $\sigma_0(\sigma_{Dj})$ of initial high frequency component standard deviations, the high frequency component base SOH($SOH_{Dj}$) decreases more, indicating that the battery pack P1 is ageing.

The SOH prediction unit 170 may predict an SOH of the battery pack P1 by calculating a final SOH(SOH) based on the cell voltage base SOH($SOH_V$), the low frequency component base SOH($SOH_{Aj}$), and the high frequency component base SOH($SOH_{Dj}$).

A formula for calculating the final SOH (SOH) may be represented by, for example, Equation 10 below.

$$SOH = \frac{SOH_V + SOH_{Aj} + SOH_{Dj}}{3} \qquad 0 \le SOH \le 1$$

$$(10)$$

According to the example shown in Equation 10, the final SOH(SOH) may be an arithmetic mean of the cell voltage base SOH($SOH_V$), the low frequency component base SOH($SOH_{Aj}$), and the high frequency component base SOH($SOH_{Dj}$). However, the present disclosure is not limited to this example, the final SOH(SOH) may be calculated as a weighted mean using first to third weight coefficients $\omega_1$, $\omega_2$, and $\omega_3$. For example, the final SOH(SOH) may be determined by a sum of the product of the first weight coefficient $\omega_1$ and the cell voltage base SOH($SOH_V$), the product of the second weight coefficient $\omega_2$ and the low frequency component base SOH($SOH_{Aj}$), and the product of the third weight coefficient $\omega_3$ and the high frequency component base SOH($SOH_{Dj}$), wherein each of the third weight coefficients $\omega_1$, $\omega_2$, and $\omega_3$ is equal to or greater than 0 and less than 1, and a sum of the third weight coefficients $\omega_1$, $\omega_2$, and $\omega_3$ is 1.

For example, the first weight coefficient $\omega_1$ may be 0.2, the second weight coefficient $\omega_2$ may be 0.3, and the third weight coefficient $\omega_3$ may be 0.5. As another example, the first weight coefficient $\omega_1$ may be 0, the second weight coefficient $\omega_2$ may be 0.6, and the third weight coefficient $\omega_3$ may be 0.4.

A method of determining values of the coefficients α, β, and γ needed to predict an SOH of the battery pack P1 according to various embodiments of the present invention will now be described with respect to an example. In the example below, it is assumed that second to tenth battery packs P2 to P10 each being the same as the battery pack P1 (hereinafter, first battery pack P1) also exist. The first to tenth battery packs P1 to P10 include a same number of battery cells and have a same arrangement structure of the battery cells. However, the first to tenth battery packs P1 to P10 may independently exist. For example, some of the first to tenth battery packs P1 to P10 may be connected in series to have a higher level output voltage, and the other battery packs may be connected to another power system or connected in parallel. That is, current profiles applied to the first to tenth battery packs P1 to P10 may be different from each other.

# EP 2 778 700 A2

As described above, FIG. 9A is a graph of cell voltage data V of the 14 battery cells included in the first battery pack P1, FIG. 9B is a graph of low frequency component data A5 of the fifth level, which is extracted by performing discrete wavelet transform multi-resolution analysis on each of the cell voltage data V, and FIG. 9C is a graph of high frequency component data D5 of the fifth level, which is extracted by performing discrete wavelet transform multi-resolution analysis on each of the cell voltage data V. The standard deviation $\sigma(\sigma_v)$ of cell voltage standard deviations, which is calculated for the first battery pack P1, is 0.001005, the standard deviation $\sigma(\sigma_{A5})$ of low frequency component standard deviations, which is calculated for the first battery pack P1, is 0.001003, and the standard deviation $\sigma(\sigma_{D5})$ of high frequency component standard deviations, which is calculated for the first battery pack P1, is $1.587865 \times 10^{-4}$.

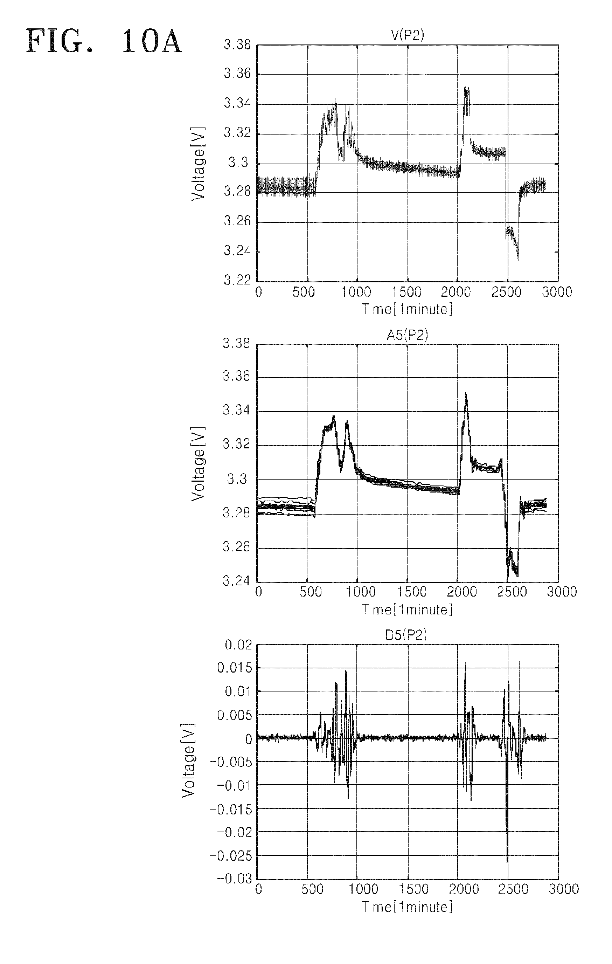

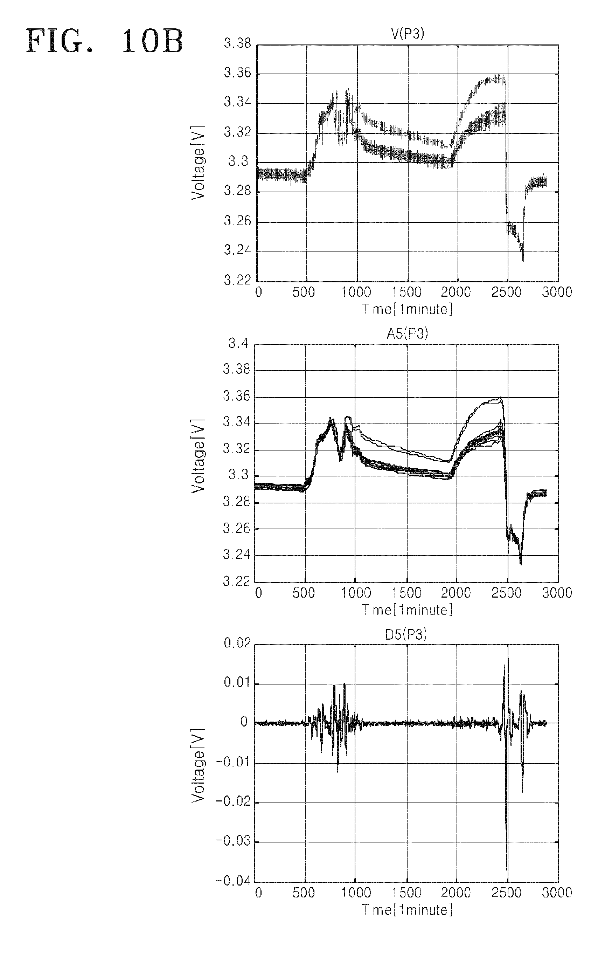

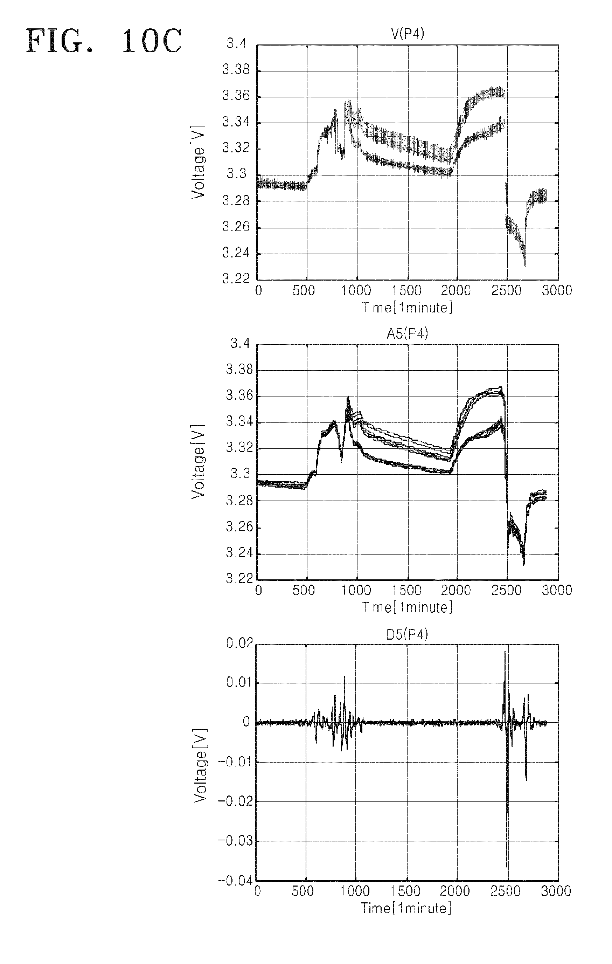

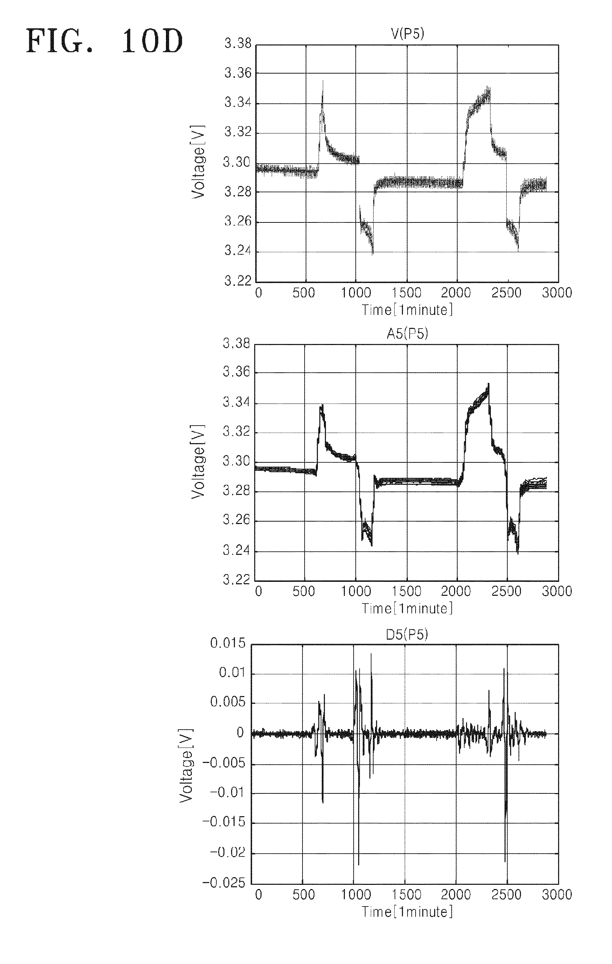

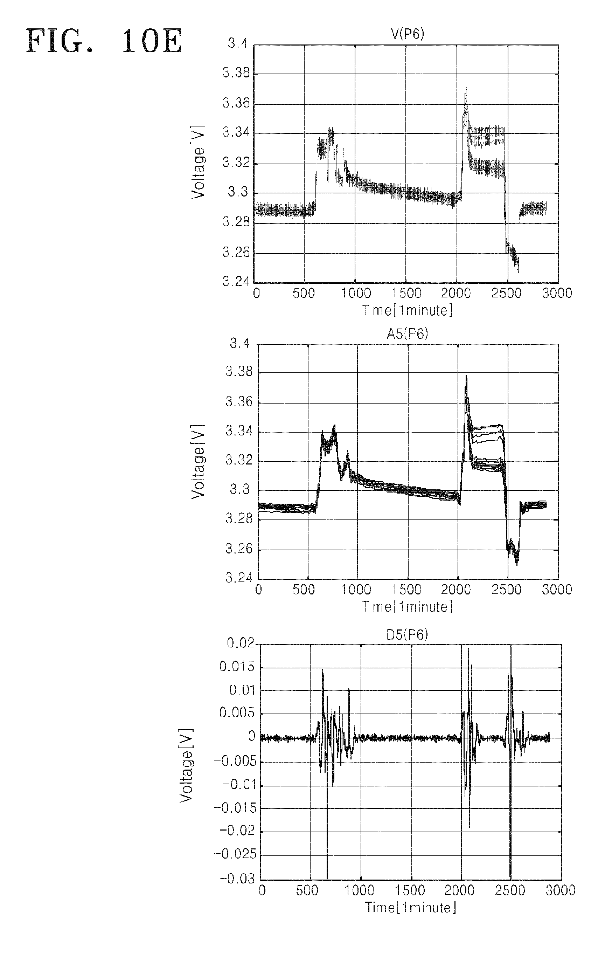

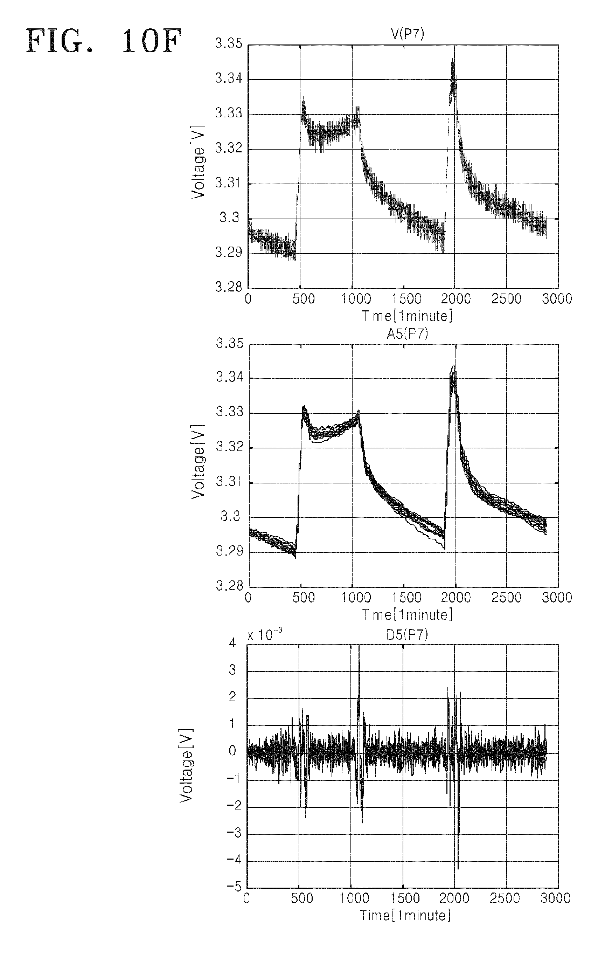

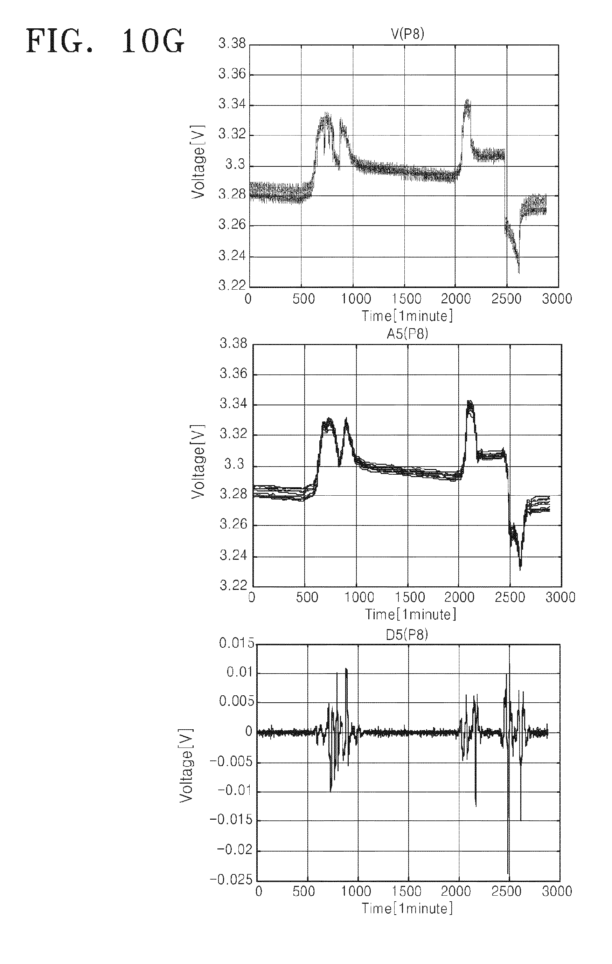

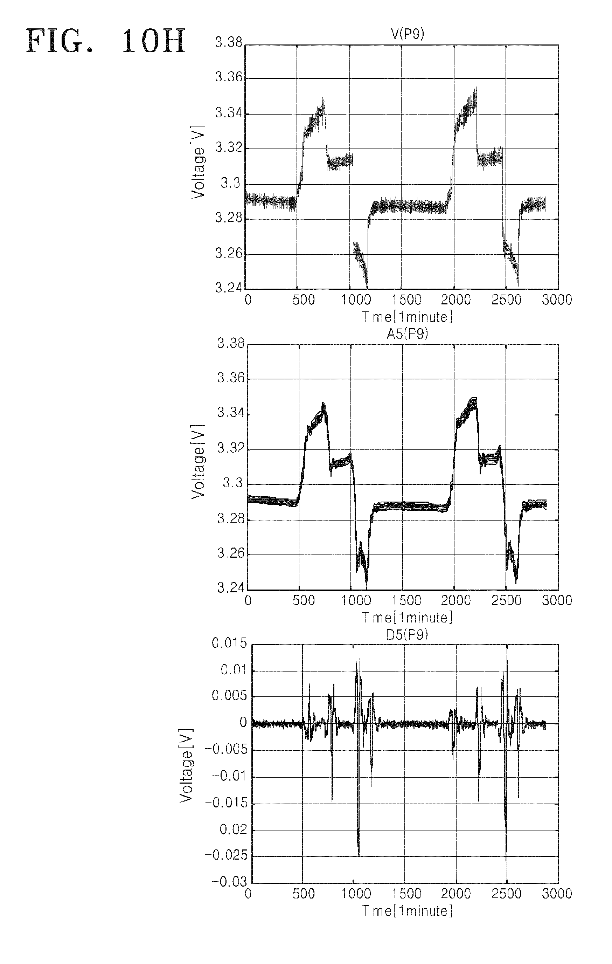

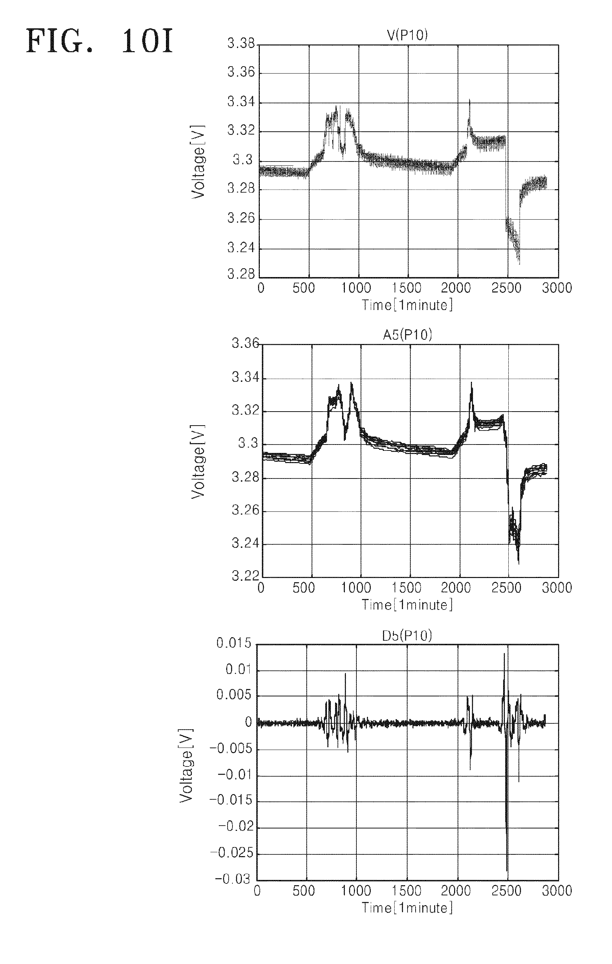

FIGS. 10A to 10I are graphs showing cell voltage data V of 14 battery cells included in the second to tenth battery packs P2 to P10, graphs showing low frequency component data A5 of the fifth level, and graphs showing high frequency component data D5 of the fifth level. For the second to tenth battery packs P2 to P10, in the same manner as the first battery pack P1, cell voltage data V may also be generated using the cell voltage detection unit 110, and the DWT unit 120 may also extract low frequency component data A5 of the fifth level and high frequency component data D5 of the fifth level based on the cell voltage data V. The first statistics processing unit 130 and the second statistics processing unit 140 may also calculate a standard deviation $\sigma(\sigma_v)$ of cell voltage standard deviations, a standard deviation $\sigma(\sigma_{A5})$ of low frequency component standard deviations, and a standard deviation $\sigma(\sigma_{D5})$ of high frequency component standard deviations for each of the second to tenth battery packs P2 to P10.

The standard deviation $\sigma(\sigma_v)$ of cell voltage standard deviations, the standard deviation $\sigma(\sigma_{A5})$ of low frequency component standard deviations, and the standard deviation $\sigma(\sigma_{D5})$ of high frequency component standard deviations for each of the first to tenth battery packs P1 to P10 are as shown in Table 4 below.

Table 4

| Pack | $\sigma(\sigma_v)$ | $\sigma(\sigma_{A5})$ | $\sigma(\sigma_{D5})$ |
|---|---|---|---|
| P1 | $10.05 \times 10^{-4}$ | $10.03 \times 10^{-4}$ | $15.88 \times 10^{-5}$ |
| P2 | $3.83 \times 10^{-4}$ | $3.96 \times 10^{-4}$ | $3.80 \times 10^{-5}$ |
| P3 | $22.86 \times 10^{-4}$ | $23.15 \times 10^{-4}$ | $13.71 \times 10^{-5}$ |
| P4 | $35.74 \times 10^{-4}$ | $36.15 \times 10^{-4}$ | $35.53 \times 10^{-5}$ |
| P5 | $6.06 \times 10^{-4}$ | $6.02 \times 10^{-4}$ | $6.24 \times 10^{-5}$ |
| P6 | $20.43 \times 10^{-4}$ | $20.58 \times 10^{-4}$ | $13.03 \times 10^{-5}$ |
| P7 | $2.02 \times 10^{-4}$ | $2.03 \times 10^{-4}$ | $2.18 \times 10^{-5}$ |
| P8 | $8.11 \times 10^{-4}$ | $8.22 \times 10^{-4}$ | $8.76 \times 10^{-5}$ |
| P9 | $7.04 \times 10^{-4}$ | $6.93 \times 10^{-4}$ | $7.13 \times 10^{-5}$ |
| P10 | $5.01 \times 10^{-4}$ | $4.99 \times 10^{-4}$ | $4.90 \times 10^{-5}$ |

The coefficient $\alpha$ may be determined from values of the standard deviations $\sigma(\sigma_v)$ of cell voltage standard deviations for the first to tenth battery packs P1 to P10. For example, the coefficient $\alpha$ may be determined as a ratio of a maximum value to a minimum value of the standard deviations $\sigma(\sigma_v)$ of cell voltage standard deviations for the first to tenth battery packs P1 to P10.

The coefficient $\beta$ may be determined from values of the standard deviations $\sigma(\sigma_{A5})$ of low frequency component standard deviations for the first to tenth battery packs P1 to P10. For example, the coefficient $\beta$ may be determined as a ratio of a maximum value to a minimum value of the standard deviations $\sigma(\sigma_{A5})$ of low frequency component standard deviations for the first to tenth battery packs P1 to P10.

The coefficient $\gamma$ may be determined from values of the standard deviations $\sigma(\sigma_{D5})$ of high frequency component standard deviations for the first to tenth battery packs P1 to P10. For example, the coefficient $\gamma$ may be determined as a ratio of a maximum value to a minimum value of the standard deviations $\sigma(\sigma_{D5})$ of high frequency component standard deviations for the first to tenth battery packs P1 to P10.

A formula for calculating the coefficients $\alpha$, $\beta$, and $\gamma$ and the values of the coefficients $\alpha$, $\beta$, and $\gamma$ in the example may be represented by Equation 11 below.

$$\alpha = \frac{\sigma_{\max}(\sigma_V)}{\sigma_{\min}(\sigma_V)} = \frac{35.74 \times 10^{-4}}{2.03 \times 10^{-4}} = 17.61$$

$$\beta = \frac{\sigma_{\max}(\sigma_{Aj})}{\sigma_{\min}(\sigma_{Aj})} = \frac{36.15 \times 10^{-4}}{2.03 \times 10^{-4}} = 17.81$$

$$\gamma = \frac{\sigma_{\max}(\sigma_{Dj})}{\sigma_{\min}(\sigma_{Dj})} = \frac{35.53 \times 10^{-5}}{2.18 \times 10^{-5}} = 16.30$$

$$(11)$$

In the example, the coefficient $\alpha$ may be determined as 17.61, the coefficient $\beta$ may be determined as 17.81, and the coefficient $\gamma$ may be determined as 16.30.

According to an increase in products using a high voltage due to increased industrialization, a battery system is generally in the form of a battery pack instead of being in the form of a unit battery cell. A battery pack includes a plurality of battery cells connected in series, in parallel, or in a combination of series and parallel. In an ideal case, a voltage unbalance does not exist between the battery cells. However, in reality, a voltage unbalance does actually exist between the battery cells. The voltage unbalance between the battery cells increases as a charging state or a discharging state continues over a long period of time. Thus, an ageing progression state of the battery pack may be detected based on the voltage unbalance between the battery cells.

According to the one or more of the above embodiments of the present invention, by predicting an SOH of a battery pack based on a voltage unbalance between battery cells, the SOH may be predicted using a cell voltage easily obtainable without an additional configuration or circuit.

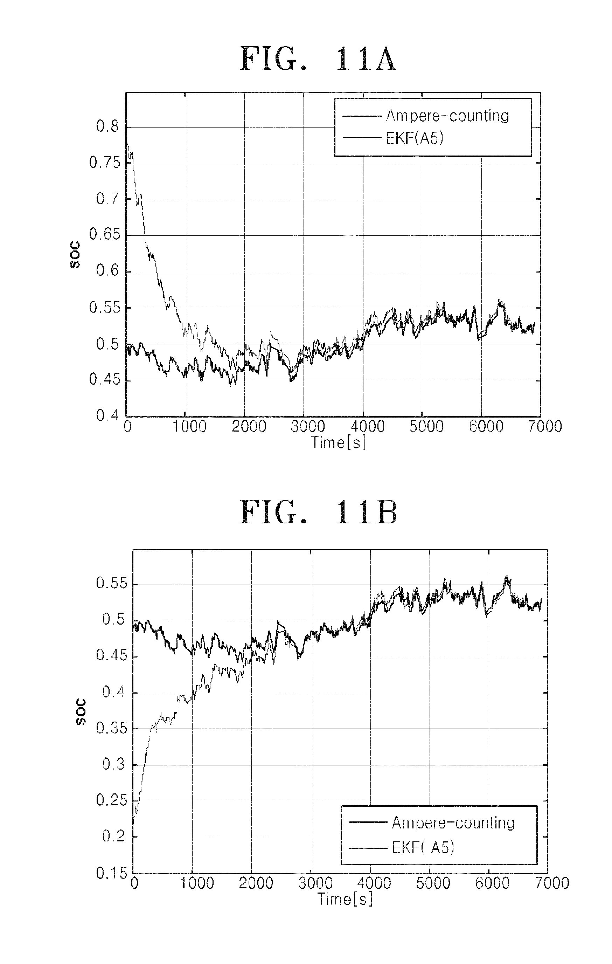

The graphs of FIGS. 11A and 11B include an SOC (indicated as "Ampere-counting") calculated by current integration and an SOC estimated by the SOC estimation unit 180 using an EKF based on an ith low frequency component data $A_{5i}$ of the fifth level according to the present invention. In FIG. 11A, an initial SOC is set as 0.8. In FIG. 11B, the initial SOC is set as 0.2.

As shown in FIGS. 11A and 11B, even if the initial SOC is set differently, the SOC estimated based on the EKF and the SOC calculated by the current integration have the same results. Even if a noise model is not applied, it may be seen that the SOC estimation performance does not deteriorate by using ith low frequency component data $A_{5i}$ of the fifth level.

A noise model has been used so as to increase the estimation performance of an SOC estimation algorithm based on the EKF. However, an addition of the noise model causes increases in algorithm complexity and accordingly expense. The present invention applies an algorithm that is concise and improved compared to the conventional method of adding the noise mode while maintaining excellent SOC estimation performance, thereby solving time and expense problems due to system development.

It will be understood by one of ordinary skill in the art that various modifications, combinations, and changes can be made according to design conditions and factors within the scope of the invention as defined by the attached claims.

## Claims

1. Apparatus for predicting state of a battery pack having a plurality of cells, the apparatus comprising:

   means (110) for providing cell voltage data (V1 - Vn) over a predetermined time period;
   means (120) for performing a discrete wavelet transform on the voltage data to obtain low frequency component data (Aj1 - Ajn) and high frequency component data (Dj1 - Djn);
   means (130, 140) for determining standard deviation values for the low frequency component data and/or the high frequency component data;
   means (170) for predicting state of health SOH of the battery pack based on the determined standard deviation values; and
   means (180, 190) for predicting state of charge SOC of the battery pack based on the low frequency component data (Aj1 - Ajn).

2. The apparatus of claim 1, wherein the means (130, 140) for determining standard deviation values is further configured to determine standard deviation values for the cell voltage data.

3. The apparatus of claim 1 or 2, wherein the means for providing cell voltage data comprises a cell voltage detection unit (110) arranged to measure cell voltages of cells in the battery pack over the predetermined time period and to digitise the cell voltages to provide the cell voltage data.

4. The apparatus of any one of the preceding claims when dependent on claim 2, wherein the means for determining the standard deviation values comprises:

   a first standard deviation calculator (130) for calculating first standard deviation values for each of the cell voltage data, low frequency component data and the high frequency component data; and
   a second standard deviation calculator (140) for calculating respective second standard deviation values for each of the cell voltage data standard deviation values, the low frequency component data standard deviation values and the high frequency component data standard deviation values.

5. The apparatus of claim 4, wherein the means for predicting the SOH of the battery pack comprises an SOH prediction unit (170) arranged to receive the second standard deviation values from the second standard deviation calculator (140).

6. The apparatus of claim 4 or 5, wherein the second standard deviation calculator (140) is further arranged to calculate respective third standard deviation values for each of initial cell voltage data standard deviation values, initial low frequency component data standard deviation values and initial high frequency component data standard deviation values.

7. The apparatus of claim 6, further comprising a storage unit (150) for storing the third standard deviation values.

8. The apparatus of claim 7, wherein the third standard deviation values are arranged to be provided to the SOH prediction unit (170) from the storage unit (150).

9. The apparatus of any one of the preceding claims when dependent on claim 2, wherein a first component (SOHv) of the predicted value for the state of health based on the cell voltage data is calculated as:

$$SOH_V = 1 - \frac{\left|\sigma(\sigma_V) - \sigma_0(\sigma_V)\right|}{\alpha\,\sigma_0(\sigma_V)} \qquad 0 \leq SOH_V \leq 1$$

$$SOH_V = 0 \qquad if \ \sigma(\sigma_V) = (\alpha + 1)\sigma_0(\sigma_V)$$

$$SOH_V = 1 \qquad if \ \sigma(\sigma_V) = \sigma_0(\sigma_V)$$

where $\sigma(\sigma_V)$ is the standard deviation of cell voltage standard deviations, $\sigma_0(\sigma_V)$ is the standard deviation of initial cell voltage standard deviations and $\alpha$ is a first coeefficient;
and/or
wherein a second component (SOH$_{Aj}$) of the predicted value for the state of health based on the low frequency component data is calculated as:

$$SOH_{Aj} = 1 - \frac{\left|\sigma(\sigma_{Aj}) - \sigma_0(\sigma_{Aj})\right|}{\beta\,\sigma_0(\sigma_{Aj})} \qquad 0 \leq SOH_{Aj} \leq 1$$

$$SOH_{Aj} = 0 \qquad if \ \sigma(\sigma_{Aj}) = (\beta + 1)\sigma_0(\sigma_{Aj})$$

$$SOH_{Aj} = 1 \qquad if \ \sigma(\sigma_{Aj}) = \sigma_0(\sigma_{Aj})$$

where $\sigma(\sigma_{Aj})$ is the standard deviation of low frequency component standard deviations, $\sigma_0(\sigma_{Aj})$ is the standard deviation of initial low frequency component standard deviations and $\beta$ is a second coeefficient;
and/or
wherein a third component (SOH$_{Dj}$) of the predicted value for the state of health based on the high frequency component data is calculated as:

$$SOH_{Dj} = 1 - \frac{\left|\sigma(\sigma_{Dj}) - \sigma_0(\sigma_{Dj})\right|}{\gamma \sigma_0(\sigma_{Dj})} \qquad 0 \le SOH_{Dj} \le 1$$

$$SOH_{Dj} = 0 \qquad if \ \sigma(\sigma_{Dj}) = (\gamma+1)\sigma_0(\sigma_{Dj})$$

$$SOH_{Dj} = 1 \qquad if \ \sigma(\sigma_{Dj}) = \sigma_0(\sigma_{Dj})$$

where $\sigma(\sigma_{Dj})$ is the standard deviation of high frequency component standard deviations, $\sigma_0(\sigma_{Dj})$ is the standard deviation of initial high frequency component standard deviations and $\gamma$ is a third coeefficient.

10. The apparatus of claim 9, further comprising a coefficient storage unit (160) for storing the coefficients to be provided to the SOH prediction unit (170).

11. Apparatus according to claim 9 or 10, wherein the predicted value for the state of health SOH is calculated as the mean or weighted mean of the first, second and third components.

12. Apparatus according to claim 9, 10 or 11, wherein the coefficients are calculated in advance based on characteristics of the battery pack, or based on characteristics of a system that includes the battery pack.

13. Apparatus according to any one of claims 9 to 12, wherein the first, second and third coefficients $\alpha$, $\beta$, $\gamma$ are calculated from the standard deviations of the cell voltage standard deviations, the low frequency component standard deviations and the high frequency component standard deviations respectively.

14. Apparatus according to claim 13, wherein the first, second and third coefficients $\alpha$, $\beta$, $\gamma$ are calculated as the ratio of the maximum value to the minimum value of the standard deviations of the cell voltage standard deviations, the low frequency component standard deviations and the high frequency component standard deviations respectively.

15. Apparatus according to any one of the preceding claims, wherein the means (180, 190) for predicting the SOC of the battery pack comprises:

an SOC estimation unit (180) for estimating cell SOCs (SOC1 - SOCn) of the plurality of cells based on the low frequency component data (Aj1 - Ajn); and
an SOC prediction unit (190) for predicting the SOC of the battery pack based on the cell SOCs ($SOC_1$ - SOCn) of the plurality of cells.

# FIG. 1

EP 2 778 700 A2

# FIG. 2

$\Phi_{j,k}(t)$

$\Psi_{j,k}(t)$

# FIG. 3

# FIG. 4

FIG. 5

# FIG. 6

Down-sampling

# FIG. 7

$A_n$   $D_n$   $\cdots$   $D_2$   $D_1$

$\dfrac{f_s}{2^{(n+1)}}$   $\dfrac{f_s}{2^n}$   $\dfrac{f_s}{8}$   $\dfrac{f_s}{4}$   $\dfrac{f_s}{2}$

# FIG. 8A

# FIG. 8B

# FIG. 8C

# FIG. 9A

# FIG. 9B

# FIG. 9C

D5

FIG. 10A

FIG. 10B

FIG. 10C

FIG. 10D

FIG. 10E

FIG. 10F

FIG. 10G

FIG. 10H

FIG. 10I

# FIG. 11A

# FIG. 11B